# EUROPEAN PATENT SPECIFICATION

(11) **EP 0 828 341 B1**
(45) Date of publication and mention of the grant of the patent: **03.12.2003**
(21) Application number: 97115291.3
(22) Date of filing: 02.09.1997
(51) Int. Cl.: H02M 7/00, H01L 25/07

(54) **Modular type power semiconductor apparatus**
Leistungshalbleiteranordnung in modularer Bauart
Dispositif semi-conducteur de puissance du type modulaire

(30) Priority: 06.09.1996 JP 23616696; 06.09.1996 JP 23616796; 18.10.1996 JP 27584196
(43) Date of publication of application: 11.03.1998
(73) Proprietor: Hitachi, Ltd., Chiyoda-ku, Tokyo 101 (JP); Hitachi Kyowa Engineering Co., Ltd., Hitachi-shi, Ibaraki 317 (JP)
(72) Inventor: Tanaka, Akira, Mito-shi, Ibaraki 310 (JP); Inoue, Hirokazu, Naka-gun, Ibaraki 319-11 (JP); Kushima, Tadao, Naka-gun, Ibaraki 319-11 (JP); Koike, Yoshihiko, Hitachinaka-shi, Ibaraki 312 (JP); Shimizu, Hideo, Mito-shi, Ibaraki 310 (JP); Saito, Ryuichi, Hitachi-shi, Ibaraki 319-14 (JP); Suzuki, Kazuhiro, Mito-shi, Ibaraki 310 (JP); Kurihara, Yasutoshi, Hitachinaka-shi, Ibaraki 312 (JP); Okada, Sensuke, Hitachinaka-shi, Ibaraki 312 (JP); Koizumi, Masahiro, Hitachi-shi, Ibaraki 316 (JP); Kajiwara, Ryoichi, Hitachi-shi, Ibaraki 319-12 (JP); Sonobe, Yukio, Hitachiota-shi, Ibaraki 313 (JP); Nakatsu, Kinya, Hitachi-shi, Ibaraki 316 (JP); Kuribayashi, Shigehisa, Hitachinaka-shi, Ibaraki 312 (JP)
(74) Representative: Finck, Dieter, Dr.Ing.

(56) References cited:
- EP-A- 0 427 143
- EP-A- 0 706 221
- EP-A- 0 791 961

## Description

The present invention relates to a power semiconductor module according to the precharacterizing portion of claim 1.

There have been known various types of power semiconductor modules, as e.g. described in EP 0 706 221 A2 or in EP 0 427 143 A2, which power semiconductor modules are comprised of hermetically sealing power semiconductor devices such as IGBTs, diodes, transistors and the like in an insulated case. These modules are applied to various types of inverters depending on their respective withstand voltages and current capacities. In particular, IGBTs are known to be easy to control since they are a voltage control type device, and have advantages such that they enable a large current high frequency operation and so on. Further, in most cases, they have a module structure in which semiconductor devices and intra-module wirings are mounted on an insulated substrate for the convenience of its use, and thereby that its metal substrate in the bottom of the module and its current conduction portions are electrically insulated inside the module. A current capacity of the module is determined by a current capacity of each semiconductor device mounted inside the module and the number of semiconductor devices connected in parallel therein. A dominant factor which determines the current capacity of each semiconductor device is assumed from the intrinsic property of the semiconductor devices to be a surface area of the device. However, provided that the number of defects per unit area of semiconductor devices is the same, then its surface area is increased substantially, its yield will decrease accordingly. Therefore, it is more advantageous to increase the number of semiconductor chips to operate in parallel rather than to increase the surface area thereof, in particular, when the surface area becomes greater than 20 mm square. Thereby, when designing a module having a larger current capacity, the number of semiconductor devices increases necessarily in proportion to an increased current capacity. Further, it is also advantageous to divide an insulating substrate to mount semiconductor devices thereon into a plurality of insulating substrates in order to ensure the mechanical strength of the substrate, precision of size, reduction of cost and the like, and further to provide internal wiring for connection between respective substrates inside the module.

As disclosed in JP-A No.61-13905, a current concentration on any part of respective semiconductors to be operated in parallel is prevented by equalizing each distance from each semiconductor to the external terminal of the module, namely, by equalizing resistance and inductance of each terminal wiring. Further, as disclosed in JP-A No. 7-2818, occurrence of inductance within the module is reduced to minimize a loss of module operation by mutual inductance effects by disposing main terminal wirings in proximity to each other and such that their currents flow in the opposite direction inverted by 180 degrees.

The profile of terminal wirings within the module is normally provided in the form of an S-type bend structure so as to ensure the strength of solder bonding by reducing stress due to thermal deformation of the module imposed on the solder bonding connecting between the wiring pattern provided on the insulating substrate and the inter-terminal wiring, or alternatively by increasing the surface area of solder bonding. JP-A No.53-119676 discloses another type of such bend structure in which a part of terminal is provided with a bend portion or a spring structure so as to absorb deformation thereby reducing stress on the solder. Further, each position of each inter-terminal wiring is connected at an equal distance on each insulating substrate for respective semiconductors to be operated in parallel. In the case where a plurality of insulating substrates are used, their inter-substrate connection was made at the same position in order to share as many components having the same substrate structure.

Control wirings for the gate, or for detection of currents of emitter and collector within the module are provided as disclosed in JP-A No.59-84458 so as to ensure freedom of shape, adequate insulation, cost reduction and so on, in which external terminals are provided integrated in the resin of the module, and electrical connection between the external terminal and its terminal wiring on the insulating substrate is provided using coated wires. Further, in the case where a plurality of insulating substrates are used, for simplification of intra-module wirings, after having bonded with solder between the bottom metal plate and the plurality of insulating substrates, inter-wiring between the plurality of insulating substrates is provided using metal wires, then the external terminal for external connection outside the module is provided only via one of the plurality of insulating substrates. As to fixing of these terminals at their respective places within the module, in most cases it depends on stiffness of each terminal wiring itself, and in particular, with respect to the control wiring, since a quantity of current flowing through its terminal is very small, its terminal is provided very thin and narrow, thereby requiring a guide to support the terminal to be provided in the resin of the module or integrally forming by embedding it in the corresponding position in the resin.

The above-mentioned prior arts are associated with the following problems.

In the case there exist more than three insulating substrates within a module, it is known to dispose these insulating substrates concentrically with respect to the center of an external terminal of the module in order to equalize each wiring extending from each internal terminal junction on each insulating substrate to the external terminal of the module. However, it is very difficult to provide for an equivalent wiring length to every terminals. Further, it is also known to provide for a bent wiring whereby a part of terminal is bent 180 degrees from the other part thereof to provide for a current path in the opposite direction so as to equalize apparent wiring inductances from each insulating substrate to the external terminal by the mutual inductance effect thereof. However, this method involves a problem that the pattern of wiring becomes very complicated and that its wiring resistance increases substantially. Still further, there arise such problems, when a large current capacity module is required and the number of insulating substrates to be operated in parallel in the module increases, and when a whole inter-substrate wiring is done inside the module, that intra-module inductance increases substantially, or that its wiring volume becomes greater proportional to an increasing current capacity, thereby increasing the terminal resistance and lowering processibility.

Further, according to a prior art method for canceling intra-module inductance by mutual inductance by overlapping the emitter terminal wiring and the collector terminal wiring in which their main currents flow in the opposite directions, when its current capacity increases and thereby its terminal width is broadened, there arises such a problem that it becomes difficult to dispose its terminal erected vertically to the metal plate of the bottom of the module. According to the method of reducing the wiring inductance by overlapping the emitter terminal and the collector terminal parallel with the bottom metal plate, there is a difference in heights between the emitter and the collector terminals from the circuit wiring junctions on the surface of the insulating substrate. Thereby, their bent wiring which electrically connects between their terminals and the circuit wiring junctions on the insulating substrate and absorbs deformation of the module so as to minimize strain imposed on solder bonding has a different height. Since the height of terminal bent wiring substantially affects the deformation absorption effect in the module, there arises such a problem that reliability in solder-bonded junctions will vary for those between the upper terminal and the lower terminal overlapped in parallel each other and having a different height. Further, according to the method of increasing the area of terminal junctions in order to improve the strength of solder bonding, deformation of the module will act on the insulating substrate via respective terminals, thereby causing a problem that the circuits formed on the surface of the insulating substrate peel off or the insulating substrate breaks, or that the area of the module increases substantially.

Still further, a value of strain imposed on a solder bonding at the terminal junction will vary depending on which part of the module the solder bonding is located when the size of the module increases necessitated for affording a large capacity. Namely, in proportion to a distance from the center of the module, a quantity of deformation of the module due to a temperature change becomes varied, thereby varying the strain imposed on the solder of wire bonding connecting between the terminal fixed on a case which houses the module and the circuit wiring on the surface of the insulating substrate in the module. The conventional S-type bend wiring absorbs deformation of the module only in the directions of height of the module and parallel to the bend direction. Therefore, when the bend is disposed toward the side end portion of the module which is perpendicular to the direction of the bend, there occurs a problem that its reliability of solder bonding deteriorates.

For facilitating module packaging, even in a large capacity and large-sized module, a gate terminal, an emitter sense terminal and a collector sense terminal for controlling the module are interconnected between respective substrates within the module, and they are joined at one terminal respectively outside the module. However, it is difficult in practice to provide for an equivalent distance for respective insulating substrates in the module from the external terminal outside the module. In particular, when the module includes 6 or more insulating substrates, a difference in distances of respective terminal junctions on the insulating substrates from their associated external terminals outside the module becomes greater, thereby causing a problem that there arises a time lag in operation between respective circuits on respective substrates. Still further, when a covered wire is used for the control wiring, although there is no problem with respect to electrical insulation, there occurs such a problem that it is difficult to fix it in the module and that a noise is caused due to electromagnetic induction from the main terminals depending on its position of layout.

Further, there occurs a difference of potentials according to their rated capacities between respective terminals within the module. When the module increases its capacity (to have an increased withstand voltage), unless an adequate and precise gap is ensured between respective terminals, there arises a problem that insulation deterioration takes place inside the module. A structure to ensure an adequate gap between respective terminals depending on stiffness of the terminal is comprised of, for example, providing a guide to part of the wiring. Depending on the shape of the guide, there may occur a void in the resin which is filled into the gap between the terminals. This void may provide a path for discharge, thereby deteriorating the insulation.

Still further, the above-mentioned prior arts are associated with the following problems.

A creep distance will increase with an increasing rating (withstand voltage of devices) of the module. In the case of a high voltage device, the height of its module inevitably increases in order to secure an adequate creep distance, that is, a distance between the metal substrate in the bottom of the module and each terminal. Further, it is also necessary to broaden a gap between respective terminals. However, all of these arrangements necessitated above will prevent provision of a more compact-sized module. Further, there is another problem that the terminals cannot be placed in the peripheral portion of the module in order to secure a sufficient creep distance between the metal substrate in the bottom of the module and the terminals over the substrate, which is a distance of a height of the module plus a lateral distance to the terminals. On the other hand, there is also a problem associated with inter-module wiring that when the width of its inter-module wiring becomes broader than the width of the terminal, its creep distance is reduced by a difference of width therebetween. In particular, when parallel plate electrodes are used in order to reduce inductance due to inter-module wirings, since these parallel plate electrodes are disposed to cover the upper surface of the module, any insulating wall which is provided higher than the upper surface of the main terminals will obstruct layout of wiring. It is further necessary to ensure an adequate distance between the wiring and the upper surface of the module including the insulating wall for securing an adequate creep distance from the wiring. These problems and disadvantages, however, have not been considered heretofore. In addition, in the case where an insulating wall or groove is provided in the form of character "⊐" in order to secure an appropriate creep distance from any particular terminal, there is a disadvantage that the direction of leading out of the wiring is limited to one direction which is not closed to outside. Further, when a groove in the form of ⊐ is provided, since the thickness of a resin portion of the module under the groove becomes thinner, there occurs a problem that a fastening strength for fastening the terminal is limited. Still further, another problem occurs that dust is collected in the insulating groove while in use, thereby degrading its insulation effect.

In a module having a plurality of external terminals for each polarity, and where there is a difference in the pitch between respective positioning of respective external terminal connections relative to the pitch between respective components in the module, that is, the pitch between respective fastening bolts, it becomes necessary to provide for a terminal corresponding to each, as a result, the number of components that constitute the module increases, thereby causing a problem resulting in an increase of cost and complication of manufacture.

When a beam is provided in part of the casing in order to reduce warp of the module, the size of the module increases by an added portion of the beam. When the overall size of the module increases further to afford a larger capacity, the same size of the beam will not assist any further to reduce quantity of the warp since its effect becomes smaller. Further, in the case where a counter-warp is provided in the base metal substrate in advance in order to secure flatness of the module during operation, it cannot suppress variation in the flatness of the base metal substrate due to temperature changes during operation of the module. Thereby, there arise such a problem that silicone adhesive which bonds the metal substrate in the bottom and an organic resin case which houses the module is caused to deteriorate and peel off, or that grease applied to ensure heat conduction between the metal substrate in the bottom and a heat dissipation fin on which the module is mounted is caused to be lost by flowing out through deformation during operation, thereby reducing the cooling effect thereof. Further, according to a method of mechanically fastening the metal substrate in the bottom and the organic resin case using bolts in the direction of major sides of the module, since fastening is provided only in the direction of the major sides of the module, directions of warp along the major sides and the minor sides of the module become opposite, rendering a convex on one side and a concave on the other side thereby forming a saddle shape. Thereby, there occur such problems that the thickness of grease varies in the surfaces of the module when packaging the module, thereby causing the cooling effect to vary depending on respective areas, and thus causing temperatures to change between respective semiconductor devices within the module, and that since a sign of plus or minus for respective quantities of deformation in two orthogonal directions is inverted, additional stress imposed on the insulating substrate used within the module becomes greater, thereby causing a crack to occur in the insulating substrate.

The object of the present invention is to provide a large capacity power semiconductor module which solves the above-mentioned problems associated with the prior art.

According to the invention this object is achieved by a power semiconductor module according to claim 1.

Preferred and advantageous embodiments of the present invention are subject matter of claims 2 to 5.

In order for the inductance in the module to be minimized and each current flowing through each semiconductor device to be balanced, a plurality of semiconductor devices of an even number are disposed on an insulating substrate within the module, then a circuit unit therefor which is comprised of an even number of such insulating substrates described above is constructed by interconnecting therebetween for constituting the module, then respective external terminals of the module are disposed outside the module corresponding to each circuit unit, and these respective external terminals corresponding to each circuit unit are interconnected outside the module to drive the module.

Intermediate level planes of terminals interconnecting between respective circuits formed on a plurality of insulating substrates within the module, and in which a main current collected from each terminal junction on the respective circuits flows are overlapped in the direction of height of the module. A sum of total projected height (as viewed from the side of the module) of a portion connecting between each terminal and each circuit on each insulating substrate is provided to be greater than a height of the intermediate plane of terminal which is in the upper direction of the module.

S-type bend is used in part of wiring for connection between each terminal and each circuit on the insulating substrate, and positions of terminal connections are aligned linearly across the module in the center portion thereof in parallel with a side which is parallel with the direction of S-bend. Further, in order to align linearly respective positions of solder bonding which are in proximity, S-bent portions are provided on both sides of an inter-substrate connection, and they are bent down such that respective positions of solder bonding are aligned linearly immediately below the inter-substrate connection. Further, with respect to the layout of terminals, the main terminal which imposes a greater stress on the solder bonding is disposed in the center portion of the module so as to prevent a unidirectional concentration of a three-dimensional thermal deformation of the module, and control terminals are disposed in the peripheral portion of the module. With respect to layout of chips, in particular, a diode chip in which electric currents are likely to concentrate is disposed in the proximity of the main terminal. When a plurality of diode chips are mounted on one insulation substrate, a plurality of main terminals are also provided on one insulation substrate in order to ensure respective currents to be balanced between respective semiconductor devices. With respect to layout of control wiring, gate wiring is disposed in the center portion of the insulation substrate, then respective semiconductor devices and circuit wirings on the insulation substrate are arranged symmetrically around the gate circuit.

Control terminals are wired in a loop in the peripheral portion of the module, i.e., outer than the main terminal wiring, and in an orthogonal direction with respect to the direction of the main terminal such that a control current flows substantially in a vertical direction relative to a main current. Further, a gate terminal and an emitter sense terminal in which their currents flow in the opposite directions are stacked in a vertical direction of the module in order to reduce wiring space therein. Still further, in order to minimize the effect of electromagnetic inductance from the main terminal, their terminals are disposed at a minimum gap from each other.

A spacer made of insulating resin is used for securing a creep distance for electrical insulation between respective terminals within the module.

The following features and functions of the invention are realized through provision of the above-mentioned means.

It is most important for any large capacity IGBT module to ensure a balance of currents among respective semiconductor devices operated in parallel. Therefore, it is particularly important to carefully design layouting on an insulation substrate of respective devices to be operated in parallel, layouting of plural insulation substrates, interconnection between the plural insulation substrates, and routing of wiring to an external terminal of the module. For example, when operating a plurality of semiconductor devices in parallel, their operation can be well balanced if their terminals are disposed corresponding to respective semiconductor devices, and their wiring from respective terminal connections to the external terminal outside the module is provided equivalently. However, in order to eliminate layout interference or electrical interference between plural different types of terminals, the size of the module becomes greater, and terminal construction becomes complex, thereby inevitably increasing intra-module inductance and wiring resistance. In order to reduce the number of terminal connections taking into account balancing of each distance from each semiconductor device, it is contemplated that it is possible to layout most efficiently if the number of semiconductor devices to be laid out on one insulation substrate is in an even number. Further, it is also contemplated that an efficient layout in the module for ensuring balanced operation can be realized if the number of insulation substrates which are interconnected within the module and must be operated in parallel with each other is in an even number. Further, the same effect can be achieved also by combining a circuit unit which includes an even number of interconnected insulation substrates as described above and another insulation substrate which is not provided as a circuit unit. Still further, the circuit unit described above can be achieved by providing external terminals respectively to an even number of insulation substrates and connecting these external terminals outside their modules.

In the large capacity IGBT module, an area of the module inevitably increases, thereby increasing the length of wiring within the module and inductance thereof, thus a high speed operation is hindered. Thereby, respective wirings are arranged as close as possible within the module to reduce the inductance by mutual inductance effect. As a typical example of such a module construction, there is a method whereby two planes of main terminals in which their main currents flow in the opposite directions are stacked in the vertical direction of the module. This method provides another advantage that the wiring space within the module is reduced. However, this method has a disadvantage that since there is a difference in heights between these two stacked planes of main terminals as much as by a thickness of the main terminal plus a distance for securing insulation therebetween, the effect of the bend provided for reducing stress imposed on solder which electrically connects the main terminal via its bend with the insulation substrate is weakened at one of the stacked main terminals which is to the side of the base. Thereby, the main terminal to the side of the base is folded again to form a bend to secure an adequate height and ensure the same effect to be achieved as that of the other main terminal which is disposed above the lower one.

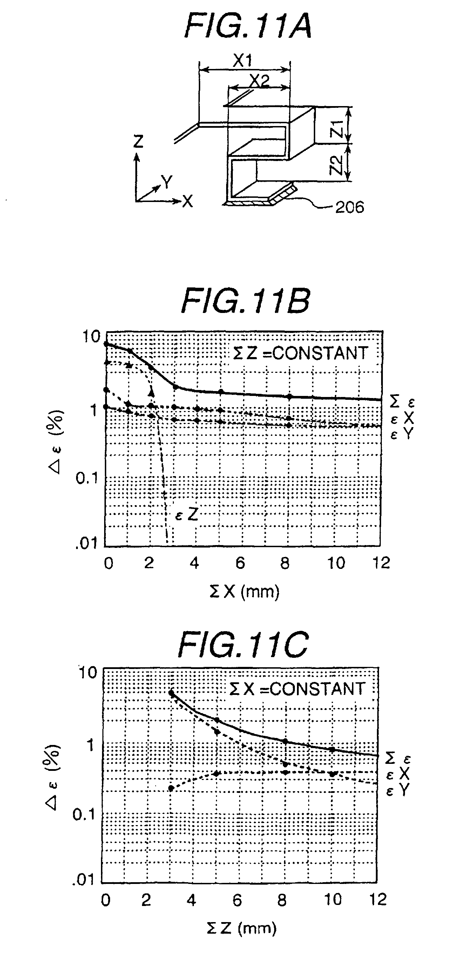

When we consider deformation in the large capacity IGBT module, it is necessary to take into account deformation in the upper direction and in the planar directions in the module. For example, with reference to Fig. 11, the effect of the bend to absorb deformation is large in the direction of Z and the direction of X which is parallel with the direction of the bend, but is small in the direction of Y which is perpendicular to X. Therefore, the direction of bend in which a large stress is applied on the solder is aligned linearly for respective main terminals of respective circuit units in the module in the center porion of the module across both sides thereof which are perpendicular to the direction of the bend. Thereby, deformation in the module in the direction perpendicular to the direction of the bend which is inherently difficult to be absorbed can be reduced by disposing in the center portion of the module as described above, thereby substantially improving reliability of solder bonding.

In the large capacity IGBT module, it is necessary to arrange such that respective control wirings for the gate, emitter sense and collector sense are provided equivalently for respective insulation substrates which are interconnected and operated in parallel within the module. It is difficult, however, to provide an individual wiring from each terminal of such control wiring to its associated external terminal hindered by other structures within the module, mainly of the main terminals. Therefore, a wiring path from each terminal's junction of the control wiring to its associated external terminal is provided not by a single individual wiring but by a loop circuit which enables a shortest wiring route to be automatically selected from respective control terminal's junctions to the external terminal depending on their positions in the module. Thereby, more uniform and parallel operation is achieved between respective insulation substrates, and improvements for faster switching capability and increased withstand voltage have been obtained. Further, provision of control wirings of the gate and emitter sense wirings in close proximity from each other and as remote as possible from the main terminals ensures the occurrence of noise due to electromagnetic induction by the main current to be suppressed, and minimization of wiring space to be attained.

For a high voltage module, it is necessary to ensure an adequate insulation distance to be maintained externally outside the module as well as internally within the module. In particular, with respect to internal terminals of the module which are liable to be deformed at the time of module assembly, they must be ensured to maintain an insulation distance. Therefore, according to the invention, an adequate insulation distance or creep distance is ensured by providing a resin spacer. What should be considered at this time is that a structure around the resin space must allow silicone gel which is poured inside the module for ensuring electrical insulation to flow freely around the resin space. For example, in a structure having a protruding nut and securing a gap between the nut and a terminal having a different potential, even if silicone gel is only partially filled in around the resin spacer, the terminal and its surrounding is at least ensured to be covered by silicone gel. Further, provision of the spacer to secure a sufficient inter-terminal distance enables a positional adjustment between the terminals and a gap holding therebetween during assembly of the module. Still further, since it becomes possible precisely to maintain the effect of mutual inductance which is determined by a distance between the main terminals, variation of internal inductance within the module is minimized.

Preferred and advantageous embodiments of the present invention will now be described with respect to the accompanying drawings in which
- Fig. 1: is a perspective view of a module embodying the invention,
- Fig. 2: is a plan view of an internal arrangement of a module embodying the invention,
- Fig. 3: is a cross-sectional view in part of a module embodying the invention;
- Fig. 4: is a perspective view indicating a structure of an emitter terminal of a module embodying the invention,
- Fig. 5: is a perspective view indicating a structure of a collector terminal of a module embodying the invention;
- Fig. 6: depicts arrangement of main terminals of a module embodying the invention;
- Fig. 7: is a plan view depicting an outer appearance of a module embodying the invention;
- Fig. 8: is an equivalent circuit of a module embodying the invention;
- Fig. 9: is a diagram indicating a lay-out of semiconductor devices on an insulation substrate of a module embodying the invention;
- Fig. 10: is a diagram indicating inductance of wiring connection of external terminals of the module embodying the invention;
- Fig. 11: indicates results of calculation of strains applied to solder bonding for terminal connection inside the module;
- Fig. 12: is a perspective view of a terminal structure embodying the invention;
- Fig. 13: indicates quantities of deformation affecting solder bonding for terminal connections at respective positions of the module;
- Fig. 14: is a diagram depicting a lay-out of control terminals of the module embodying the invention;
- Fig. 15: is an appearance in part of a control terminal of the module of the invention;
- Fig. 16: depicts an inter-terminal gap structure for securing a gap between terminals of the module of the
- Fig. 17 invention,: depicts another inter-terminal gap structure for securing a gap between terminals of the module of the invention,
- Fig. 18: depicts still another inter-terminal gap structure for securing a gap between terminals of a power semiconductor module,
- Fig. 19: depicts a conventional inter-terminal gap structure,
- Fig. 20: is a plan view of a first embodiment of the invention,
- Fig. 21: is a cross-sectional view of the first embodiment of the invention,
- Figs. 22 (a) to (c): are plan views in part of the first embodiment of the invention,
- Fig. 23: is a plan view in part of Fig. 22(a) of the first embodiment of the invention,
- Fig. 24: is a circuit diagram of the first embodiment of the invention,
- Fig. 25: is a perspective view of a schematic construction in part of the first embodiment of the invention,
- Fig. 26: is a perspective view of a schematic construction in another part of the first embodiment of the invention,
- Fig. 27: is a schematic block diagram indicating an equivalent circuit of a second embodiment of the invention,

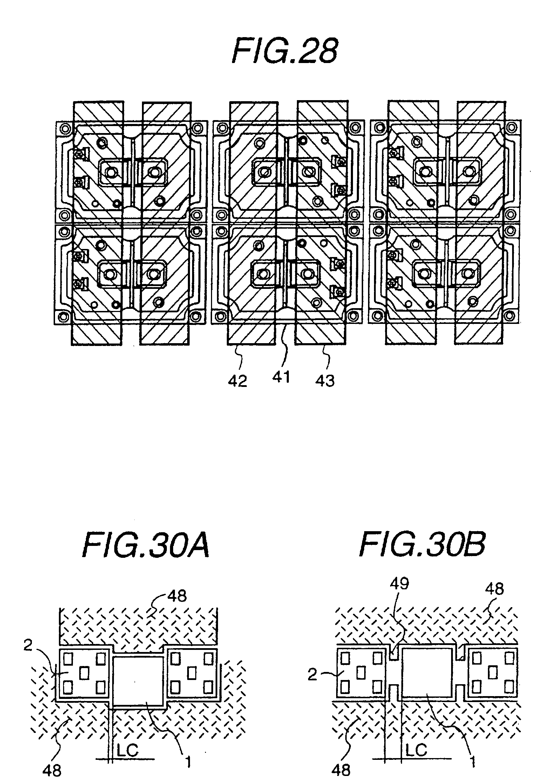

- Fig. 28: is a plan view depicting a schematic arrangement of the second embodiment of the invention,
- Figs. 29 (a) to (c): are plan views in part of the second embodiment of the invention having a modified arrangement,
- Figs. 30 (a) and (b): are plan views in part of the first embodiment of the invention having a modified arrangement,
- Fig. 31: is a plan view of a power semiconductor module,
- Fig. 32: is a cross-sectional view of the module of Fig. 31,
- Figs. 33 (a) and (b): are cross-sectional views in part of a power semiconductor module depicting in detail a portion between its collector sense terminal and its bottom metal substrate,
- Fig. 34: shows cross-sectional views of a power semiconductor module depicting a portion between its collector terminal and its emitter terminal,
- Fig. 35: shows cross-sectional views of a power semiconductor module having a laminate bus bar interposed between its collector terminal and its emitter terminal,
- Figs. 36 (a) and (b): are cross-sectional views of a power semiconductor module having a creep distance between its collector sense terminal and its emitter sense terminal,
- Figs. 37 (a) and (b): are cross-sectional views of a power semiconductor module,
- Fig. 38: is a cross-sectional view of a power semiconductor module having an insulation wall mounted,
- Fig. 39: is a schematic diagram depicting respective positions of respective terminals on a power semiconductor module,
- Fig. 40: is an equivalent circuit of a power semiconductor module,
- Fig. 41: is a rear surface view of a module case of a power semiconductor module,
- Fig. 42: is a rear surface view of a power semiconductor module,
- Fig. 43: is a diagram depicting a package of power semiconductor modules,
- Fig. 44: is a diagram depicting another package of power semiconductor modules, and
- Fig. 45: is a diagram depicting still another package of power semiconductor modules.

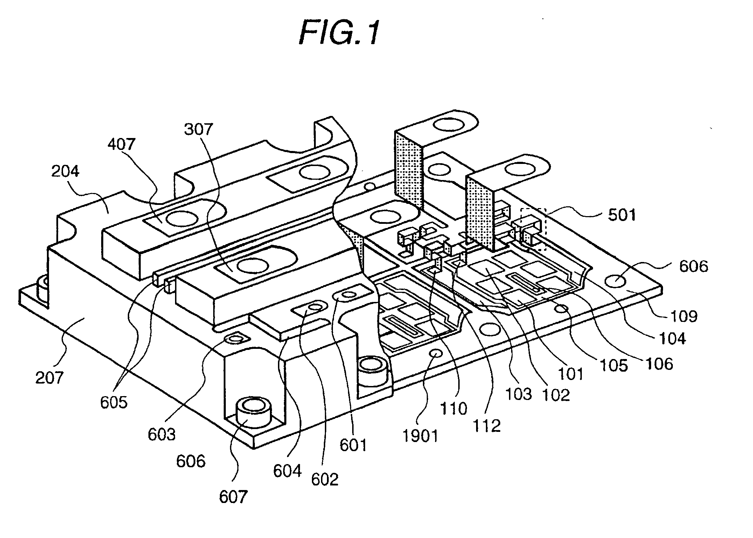

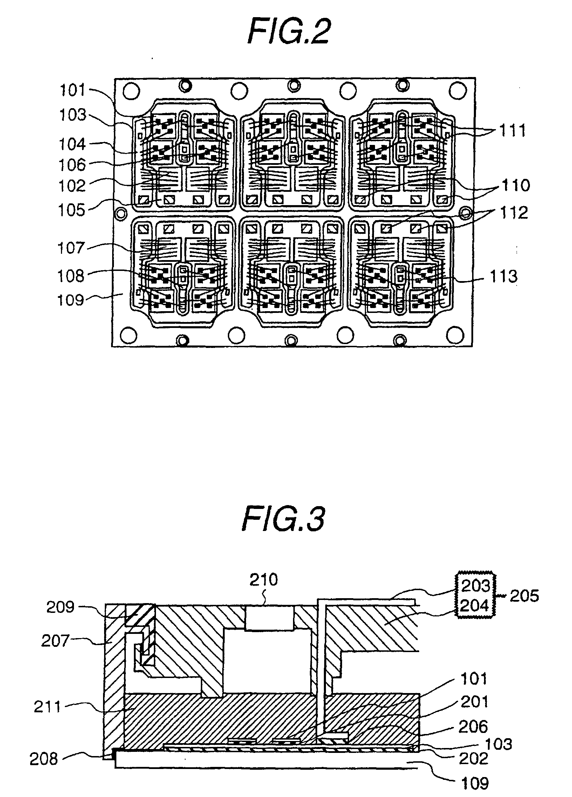

With reference to Fig. 1, a perspective view of a module embodying the invention is depicted. A top cover in part of Fig. 1 on the right-hand side is cut out to expose an internal structure thereof. A plurality of Cu-foiled AlN substrates 103 (hereinafter referred to as Cu-AlN substrate) are disposed on a bottom metal substrate 109. Then, a plurality of IGBTs 101 and a plurality of diodes 102 are disposed on each Cu-AlN substrate 103. Internal wiring within the module is provided from positions of emitter terminal connection 110 and of collector terminal connection 112 on Cu-AlN substrate 103 to external emitter terminal 307 and external collector terminal 407 provided in the upper portion of the module. S-type bend structure 501 is used in part on the way of the internal wiring in order to ensure reliability of solder bonding for respective terminals. A resin case of the module is comprised of a resin wall 207 and a terminal block 204 which is integral with a resin cover. Further, electrical insulation inside the module is ensured by filling gel resin which is not shown. Details of respective portions of the module will be described with reference to Fig. 2 and following figures.

A plan view of the inside of a module embodying the invention is depicted in Fig.2, and a cross-sectional view in part of the module of the invention is depicted in Fig.3. Four IGBT devices 101 and two diodes 102 are bonded by solder 201 on each Cu-AlN substrate 103. An emitter wiring circuit region 104, a collector wiring circuit region 105 and a gate wiring circuit region 106 are formed on the surface of Cu-AlN substrate, and IGBT devices 101 and diodes 102 are bonded on the surface of collector wiring region 105. Each device is wired to emitter wiring circuit region 104 using metal wire 107. Resistance 108 is mounted on gate wiring circuit region 106 which is electrically connected using metal wire 107 with a gate pad of each IGBT device 101. Six plates of Cu-AlN substrates 103 each mounting semiconductor devices in the manner described above are bonded to bottom metal substrate 109 with solder on their rear surfaces. Electrical connection between respective insulation substrates is provided by terminal block 205 which has terminal 203 integrated in resin case 204 and via solder 206. A total number of main terminal connections from the terminal block 205 on each Cu-AlN substrate 103 is 7, which number includes two connecting positions respectively for emitter terminal 110, emitter sense terminal 111 and collector terminal 112, and one connecting position for gate terminal 113, thereby a total number on one module in this case amounts to 42. After interconnection of terminal block 205, a resin case 207 is integrated by bonding using adhesive 208 which is a silicone rubber. Then, terminal block 205 and case 207 are fixed firmly using thermo-setting epoxy resin 209. Then, silicone gel 211 is poured into the module from resin inlet 210 so that the whole part of the terminal is covered by the gel, then, the inlet is sealed with a silicone rubber cover thereby completing the process of manufacture of the module.

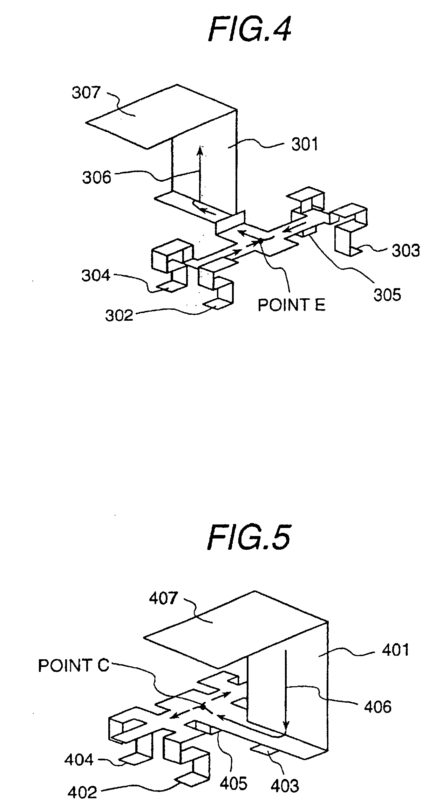

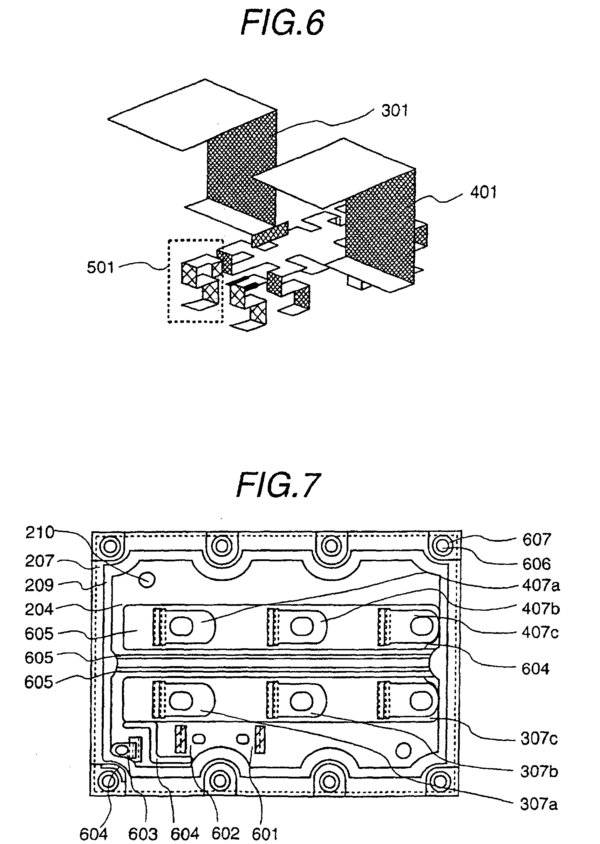

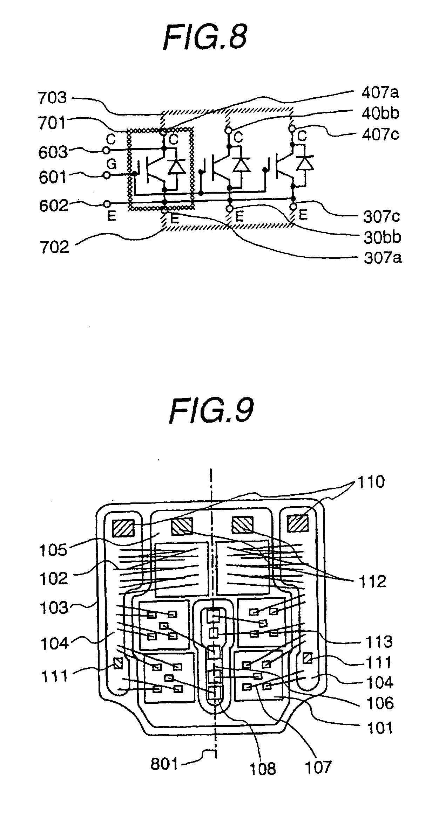

A structure of main terminals according to the invention is indicated in Figs.4 to 6. Fig.4 depicts a structure of a main terminal of emitter. This main emitter terminal 301 contacts with a first Cu-AlN substrate 103 at two contact positions 302 and 303, and contacts with a second Cu-AlN substrate 103 which is mounted in the opposite direction to the first Cu-AlN substrate at two other contact positions 304, 305, thereby collecting currents from these four contact positions, allowing them to flow through current path 306 to be directed to emitter external terminal 307. In this structure of emitter terminal, each distance from each connection position 302-305 to point E where each current joins in the drawing of Fig.4 is the same, thereby causing no current unbalance therebetween. A structure of a main collector terminal is depicted in Fig.5. There are two connecting points 402 and 403 which connect between the first Cu-AlN substrate 103 and collector terminal 401. There are also two connecting points 404 and 405 which connect between the second Cu-AlN substrate 103 disposed opposite to the first Cu-AlN substrate 103 and the collector terminal 401. Thereby, a main current 406 from emitter external terminal 407 is divided into four subcurrents to flow through these four connecting points. In this structure of collector terminal, each distance from point C on the plane of the collector terminal to each connecting point in contact with Cu-AlN substrate 103 is substantially the same, thereby preventing occurrence of unbalanced current flow therebetween. Figure 6 depicts a pair of emitter terminal 301 in conjunction with collector terminal 401. Respective terminal level planes having point E or point C where its main current flows are disposed to overlay the other one, thereby canceling respective wiring inductance by mutual inductance. Figure 7 is an external top view of the module. As module's external terminals there are disposed three sets of emitter external terminals 307(a-c) of Fig.6 and three set of collector external terminals 407(a-c) of Fig.6. In addition, as control terminals there are disposed gate external terminal 601, emitter sense external terminal 602 and collector sense terminal 603. Module mounting holes are provided in case 207 embedded integral with metal case ring 607 serving as a guide. Thereby, during mounting of the module, case 207 and bottom metal substrate 109 are fastened together firmly such that there is no risk of loosening of the case 207. Insulating groove 604 and insulating wall 605 are provided to secure insulation distance between respective terminals outside the module. In the periphery of the module there are provided mounting holes 606 for mounting the module. Figure 8 depicts an equivalent circuit of the module embodying the invention. A unit of IGBT 701 is composed corresponding to each of the main terminals (a-c) indicated in Fig.7, and respective units which are operated in parallel with each other externally via wiring 702, 703 constitute a module of the invention.

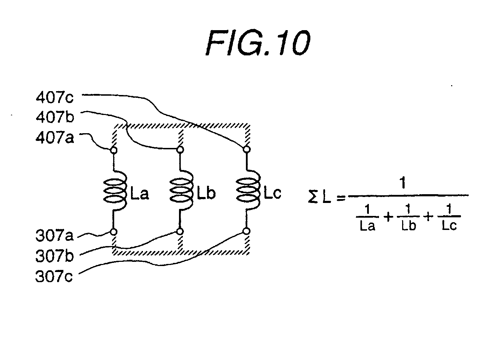

According to this embodiment of the invention, it is arranged such that the number of semiconductor devices mounted on each Cu-AlN substrate 103 is specified to be even number, that each IGBT unit 701 to be operated in parallel using intra-module terminal wiring is comprised of an even number of Cu-AlN substrates 103, and that IGBT units 701 provided in an odd number inside the module are wired externally outside the module to be operated in parallel with each other. Combination of these arrangements of the invention provides the following features and advantages.
(1) When mounting two or more semiconductor devices on a Cu-AlN substrate 103, it is most preferable to arrange them symmetrically with respect to a center line thereof in order to secure a balanced current distribution therebetween. Thereby, according to this embodiment of the invention with reference to Fig. 9, a layout of semiconductor devices on an insulation substrate is arranged such that they are disposed symmetrically with respect to a center line 801 drawn vertically across resistor 108. According to this arrangement, respective semiconductor devices can be packed more densely, thereby realizing a more compact module advantageously. On the other hand, in the case where an odd number of IGBT devices 101 or diodes 102 are to be mounted, they must be mounted along a center line, thereby causing dead space to occur. In designing each current path down to each connecting position of each terminal, it is necessary to give priority to a layout of diode 102 in which a current concentration is likely to occur. In this embodiment of the invention which has two diodes 102, two emitter terminal connecting positions 110 and two collector terminal connecting positions 112 are provided respectively corresponding to these two diodes 102 so as to equalize respective distances from these two diodes. The number of collector terminal connecting positions is not limited to 2, but one collector terminal connecting position will do if its terminal connecting position is placed in the center of each diode 102. However, in consideration of a balance with the number of emitter terminal connecting positions, ease of bonding of terminal block 205 during module assembly, and prevention of tilt of the block, the two collector terminal connection positions are provided. However, in the case of a symmetrical arrangement of odd number of devices, since an area of wiring positions of metal wire 107 is required corresponding to each device, terminal connecting positions in the number corresponding to respective devices are required. This leads to an increased size of the module and complexity of terminal structures.
(2) For arrangement of Cu-AlN substrates 103 to be operated in parallel within a module, it is contemplated to ensure each terminal connection leading from each substrate to each external terminal connecting point of the module to be wired equivalently. When the number of substrates is an even number, and if each wiring of terminal is arranged symmetrically on each substrate, it becomes possible to lead out each terminal to each external terminal equivalently, thereby without distorting current balance. However, in the case having an odd number of substrates to be arranged symmetrically, they must be arranged concentrically around external terminals placed in the center portion. If a method to fold down ends of a terminal is used, it still becomes possible to equalize apparent circuit inductance, however the shape of terminal becomes complex, and further, its wiring resistance increases substantially. In this embodiment of the invention, since two Cu-AlN substrates 103 in each unit are arranged to operate in parallel, an equivalent distance of wiring can be provided readily from each terminal connecting point to its associated node point E or C where currents join together or divide.
(3) In this embodiment of the invention, three units having Cu-AlN substrates operating in parallel are provided within the module, and module external terminals corresponding to the number of the units are provided. When assembling the module, these external terminals are connected externally so as to be able to operate each unit in the module in parallel. Thereby, advantageously, a total inductance EL of the module can be reduced smaller than inductance of each terminal La, Lb, Lc as indicated in Fig.10. Further, if a parallel plate wiring or laminate bus bar, for example, is used for external connection outside the module in order to operate these units in parallel, almost no unbalance occurs between these units. In the case if inter-unit wiring is provided inside the module, the inter-unit wiring in consideration of balancing between respective units becomes very complicated as complex as the inter-substrate wiring having an odd number of substrates. Further, in the case of a large current capacity module which requires a large volume of terminal wiring(broader or thicker)by taking into account the current capacity thereof, there is a disadvantage that manufacture and assembly of the terminals become more complicated.

The structure of interconnection wiring for interconnecting between Cu-AlN substrates within the module will be described. As explained with reference to Fig.6, respective level planes of terminals having points E and C where respective main currents flow are overlaid so as to reduce wiring inductance by their mutual inductance effect. On the other hand, in order to reduce stress applied to solder 206 for bonding between each main terminal connection and Cu-AlN substrate 103, each main terminal connection has an S-type bend 501 at its bottom portion. Effects of this S-type bend will be described with reference to Figs.11(a)-(c). Fig.11(a) is a schematic diagram indicating a model of the S-type bend of the invention. This bend has lengths of X1 and X2, and heights of Z1 and Z2. Each effect thereof in each direction is determined by a sum of respective lengths or heights. That is, we need only consider ΣX,ΣZ(where ΣX=X1+X2, ΣZ=Z1+Z2). Fig.11(b) indicates a result obtained by varying ΣX with ΣZ being fixed, and Fig.11(c) indicates a result obtained by varying ΣZ with ΣX being fixed. In both cases of (b) and (c), strains of solder Δ ε are indicated as separated into respective directions of X, Y and Z. In either case, by provision of the S-type bend structure, strain ε Z corresponding to deformation of the case in the direction of Z rapidly decreases (whereas in the drawing of (c), the value of ε Z was too small to be indicated, as small as by three digits). On the other hand, it is more effective for reducing strain ε X in the direction of X to lengthen ΣZ rather than to lengthen ΣX. In other word, when height ΣZ of the S-type bend differs, the value of strain applied to solder at terminal connection is caused to change, thereby changing reliability of solder bonding 206. In consideration of the foregoing discussions, each height of each S-type bend provided for interconnection of a plurality of insulation substrates of the invention is specified to be the same. That is, a summation of heights of any S bend (as projected in the side direction of the module) of main terminals which are overlaid is provided higher than a height of the main terminal in the upper side. In this embodiment of the invention, emitter terminal 301 which is in the bottom side in Fig.6, i.e., toward metal substrate 109 is folded down to secure its height to the level of the plane of point C of collector terminal 401 where its main current flows, then is provided with an S-type bend structure. Thereby, the same reliability of solder bonding 206 is ensured for both connections of emitter terminal 301 and collector terminal 401 on Cu-AlN substrate 103.

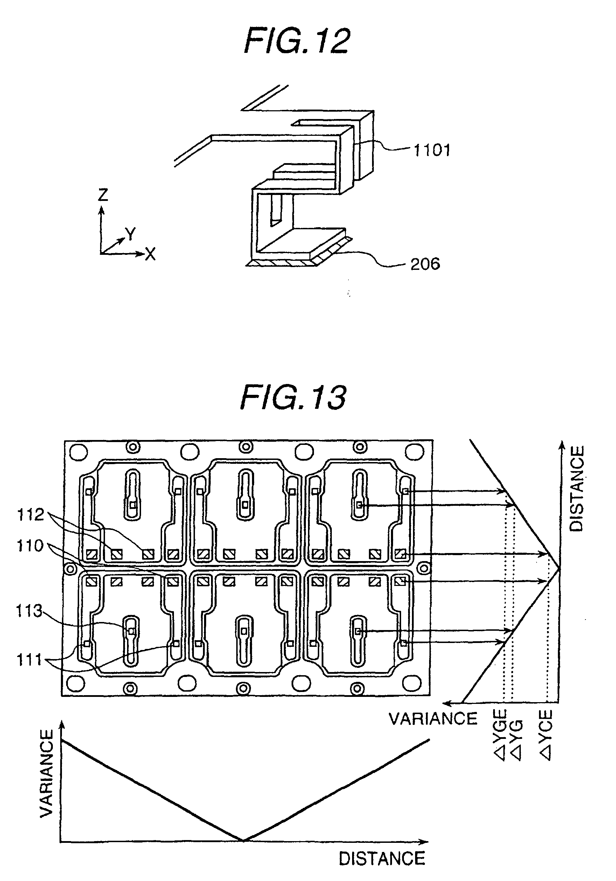

Little effect is found to exist with respect to deformation in the direction of Y from the result of Fig. 11. As one of countermeasures, a method of providing a slit 1101 in each terminal cut out in its width direction which is Y direction is contemplated as depicted in Fig. 12. In this instance, positioning and extent of the slit must consider both prevention of solder rising and a current balancing. With respect to the solder rising, the bottom portion of the slip 1101 is stopped at a higher level than the bottom plane of the terminal in contact with solder, thereby avoiding the rising of solder, or a problem of an excessive solder. Further, with respect to the current flow, it is ensured that a current density will not exceed its allowed value due to the provision of the slit, and that an equal quantity of current flows through each portion on both sides of the slit by providing a same width thereto. Besides the provision of the slit, it can be also dealt with by proper arrangement of the terminals within the module. Fig. 13 shows quantities of variance at respective terminal connections depending on their corresponding positions within the module under a constant temperature change. The quantities of variance at respective terminal connections result from a thermal deformation of Cu-AlN substrate 103 which is firmly fixed with solder 206 and/or bottom metal substrate 109, and from a difference of thermal expansion coefficient of a portion which is firmly fixed with resin case 204 of terminal block 205. Hence, the quantity of variance is zero in the center portion along each center axis, and increases gradually moving toward peripheral side portions. The S-type bend has a smallest effect in the direction perpendicular to the direction of the bend. Therefore, it is arranged in the module of the invention such that the positions of terminal interconnections are disposed substantially along a center portion across both minor sides which are perpendicular to the direction of the bend in order to minimize the quantity of variance ΔYCE which affects solder 206 greatest, thereby minimizing strain applied thereto. Thereby, variation of strain depending on where its terminal connection is placed can be minimized. The same effect can be obtained also for the terminal which does not use the S-type bend. Further, since the positions of terminal interconnections are aligned in a row when assembling the module, there are such advantages that visual inspection of a plurality of solder 206 after completion of their bonding becomes easy, and in consequence that each height of each terminal becomes easy to be even with each other. Still another advantage is that by placing in the center portion of the module the main terminals which have a greater current capacity thereby a greater volume, hence are not likely to be effected by the bend, overall reliability of the module can be improved substantially. Furthermore, the provision of the main terminals in the center portion of the module helps to shorten the length of wiring for interconnecting their associated terminals, thereby minimizing inductance and wiring resistance.

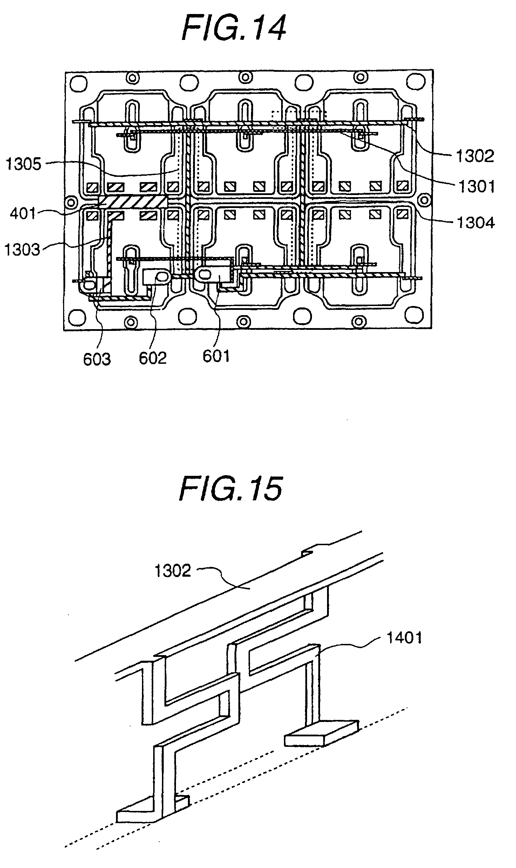

Now, structures of control terminals of the module embodying the invention will be described. With reference to Fig.14, a gate terminal 1301, emitter sense terminal 302 and collector sense terminal 1303 are shown. One gate terminal 1301 leading out from each Cu-AlN substrate 103, thereby six gate terminals leading out in all from the module are wired to an external gate terminal 601. Two emitter sense terminals 1302 leading out from each Cu-AlN substrate 1301, thereby 12 emitter sense terminals in all from the module are wired to an external emitter sense terminal 602. Further, collector sense terminal 1303 which is formed integral with collector terminal 401 in one IGBT unit 701 is directly wired to an external terminal 603 of the module. Gate terminals 1301 and emitter sense terminals 1302 of three Cu-AlN substrates 103 which are aligned in a row are interconnected with one horizontal wiring, respectively. Interconnection between the upper arm and the bottom arm Cu-AlN substrates 103 which are disposed oppositely are interconnected by two wirings 1304 and 1305. In the case of a large-sized module having a single external terminal for external terminals 601 and 602 respectively, there inevitably occurs a difference in lengths of internal wiring therefor depending on their corresponding internal arrangements. In order to reduce such difference as much as possible, interconnection between the two opposing substrates is provided using the two wirings 1304 and 1305. Thereby, a path of current from an internal position which is remote from the external terminal is automatically selected therebetween so as to provide a shortest optimum path for its current to flow. Further, with respect to the layout of their wiring, portions of their wiring which are parallel to the direction of the main current (i.e., wiring for interconnecting between three Cu-AlN substrates aligned horizontally) are disposed remote from the main terminal with an adequate distance from the center of the module in order to suppress the influence of electromagnetic noise. Furthermore, portions of their wiring which run in close proximity to the main terminal are disposed perpendicular to the direction of the main current (which corresponds to the wiring which interconnects between the two substrates which are disposed oppositely in the unit). Still further, by closely placing gate terminal 1301 and emitter sense terminal 1302 with a minimum gap therebetween, the influence of electromagnetic inductance from the main terminal is suppressed to minimum. For this purpose, each connection of terminals between the three Cu-AlN substrates aligned horizontally is provided by each horizontal wiring with a reduced space, and interconnection of terminals between the two opposite substrates in the unit of the module is provided by overlapping their terminals in the vertical direction. Respective positions of connection of respective control terminals are aligned in the direction having the minimum bend effect as depicted in Fig.12, and also they are arranged such that the quantity of variance ΔYG of gate terminal 113 at its connecting position becomes substantially equal to the quantity of variance Δ YGE of emitter sense terminal 111 at its connecting position. Further, they are disposed symmetrically on each Cu-AlN substrate 103, and as a means for arranging respective positions of their terminal connections in a row across the module, branch terminals with S-bend are folded down from both sides of the terminal which interconnects respective substrates aligned as indicated in Fig.15 so that directions of S-bend of respective wiring terminals are aligned in the same direction as viewed from each substrate, thereby that two adjoining positions of wiring terminals can be provided from one terminal strip. Thereby, layout of metal wire 107 on the substrate which is subject to the influence of the bend position can be rendered equal between respective substrates.

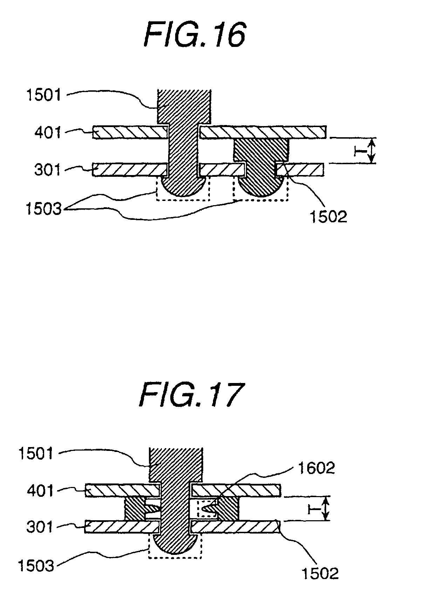

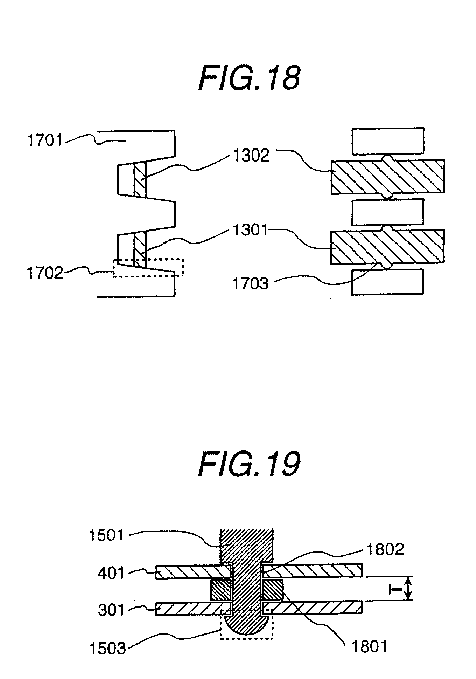

With reference to Figs.16-18, a method for securing a gap between terminals inside the module is shown. Particular points to be noted in this method are to ensure a terminal gap T necessary for electrical insulation between respective terminals, and ensure silicone gel which is poured into the module to fill in completely the peripheral portion of the terminals without allowing a void space to be formed across the terminals. By way of example of Fig.19, when a resin ring 1801 having substantially a same diameter as that of a resin pin 1501 is mounted between respective terminals in order to secure an insulation gap therebetween, there is a risk that silicone gel is not filled in a gap 1802 between the resin pin and the resin ring, thereby causing a short circuit through the gap 1802. Hence, according to this embodiment of the invention as indicated in Fig.16, collector terminal strip 401 is inserted into a fixing through-hole preformed in a resin pin 1501, which is formed integral with terminal block 205 for securing a gap between main terminals, then emitter terminal strip 301 having mounted a resin pin 1502 having a thickness necessary for securing the terminal gap is inserted into another fixing through-hole of the resin pin 1501. Further, portion of the resin pin is subjected to thermal caulking to seal and fix both main terminals. Alternatively, as indicated in Fig.17, after insertion of collector terminal 401, a resin ring 1601 having a protrusion 1602 for ensuring a space in the periphery thereof which can be filled completely with silicone gel afterward is inserted, then emitter terminal 301 is inserted in the fixing hole, and the resin ring is subjected to thermal caulking for providing a cap. The thermal caulking for fixing or providing the cap is not limited to the thermal caulking, but a cotter pin, screw cap or the like will do as well. Still further, with reference to Fig.18, by taking advantage of conformability of resin, taper 1702 is provided in part of terminal guide 1701 which is integral with terminal block 205, then a terminal strip is forced into this terminal guide with a taper to be firmly fixed therein. If a protrusion 1703 is provided in part of the terminal strip as depicted in the right-hand drawing of Fig. 18, it will be effective for more easily and surely fixing therein. Fig.18 depicts an example in which two terminals are aligned in parallel in the horizontal direction, however, the same method of providing the taper can be used to secure terminal positions and inter-terminal gap in the vertical direction as well.

According to the present invention, a large capacity module having a plurality of semiconductor devices which must be operated in parallel is ensured to be able to balance respective current flows between respective semiconductor devices, thereby allowing a high speed switching operation, and improving the withstand voltage of the module. Further, since its parallel operating circuits can be formed outside the module, inductance within the module can be reduced substantially. Still further, even for a module having substantially a large capacity and a large size, reliability of solder bonding for connecting between its terminals and its insulation substrate has been made uniform throughout the module, thereby substantially improving the overall reliability of the module.

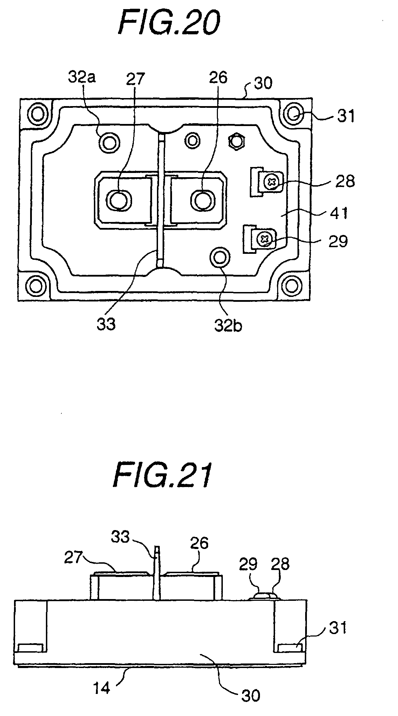

Now, with reference to Figs.20-21, an outer appearance of an IGBT module embodying the invention is shown. Fig.20 is a plan view of the module, and Fig.21 is a cross-sectional view thereof. On the outer surface of the module 41, there are provided emitter terminal's external connection 26, collector terminal's external connection 27, gate terminal's external connection 28 and auxiliary emitter terminal's external connection 29, which were led out from resin case 30 outside the module. Gel inlet ports for pouring gel into the resin case 30 are provided to the sides of the emitter and the collector, respectively, and these inlet ports are sealed by caps 32a and 32b. Insulation fin 33 is provided on the surface of the case 30 to secure a creep insulation distance between emitter terminal's external connection 22 and collector terminal's external connection 27. In the bottom of the module as depicted in Fig. 21, a metal base substrate 14 is bonded with the case 30. The metal base substrate 14 is provided with a mount hole 31 for mounting the module on a heat sink provided externally.

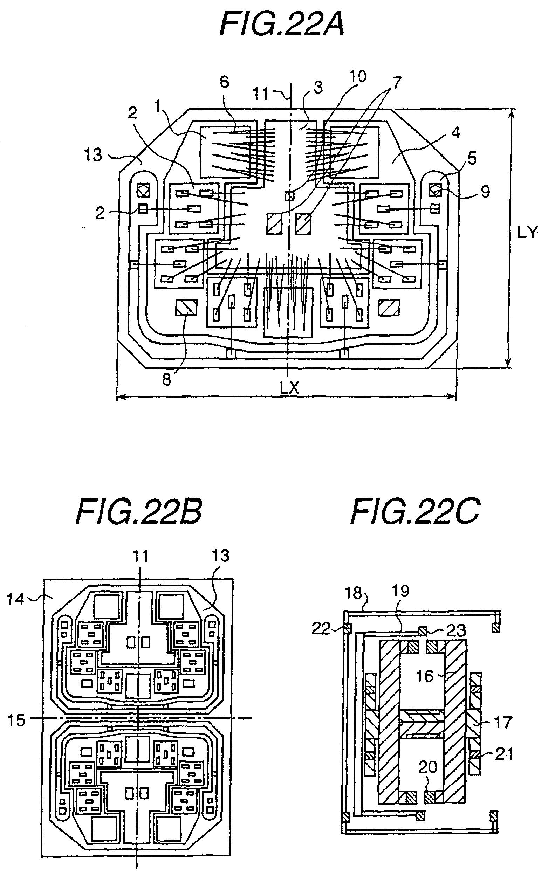

With reference to Figs.22(a)-(c), internal structures and arrangements of this embodiment of the invention are depicted. Two insulation substrates 13 each having copper foils bonded thereon are solder-bonded on the surface of a base substrate 14. Insulation substrate 13 uses aluminum nitride as its main insulating material. Main materials suitable for this insulating substrate must have a high heat conductivity so as to be able to dissipate heat generated by semiconductor devices and conduct the heat externally. Thereby, in addition to aluminum nitride used in this embodiment, ceramics materials such as aluminum oxides or a good heat conductivity composite material having electrical insulation can be applied as well. On each insulation substrate 13, there are formed a collector wiring pattern 4, an emitter wiring pattern 3 and a gate wiring pattern 5 using copper foils. On the surface of the collector wiring pattern 4, there are solder-bonded six IGBT semiconductor devices 2 and three diode semiconductor devices 1. These wiring patterns are arranged on the insulation substrate such that emitter wiring pattern 3 is disposed in the center portion of the insulation substrate 13, that collector wiring pattern 4 is disposed to surround the emitter wiring pattern, and that gate wiring pattern 5 is disposed around the outer periphery of the collector wiring pattern 4. In Figs.22(a) and (b), corners of each wiring pattern are schematically drawn using straight lines, but actually they are formed in curves.

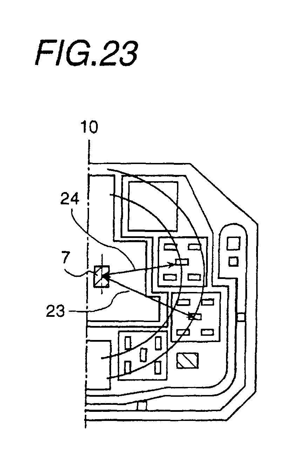

Emitter wiring pattern's terminal connection 7 is disposed in the center portion of the emitter wiring pattern which is placed in the center of insulation substrate 13. As indicated in Fig.23, IGBT semiconductor devices and diode semiconductor devices are disposed on a circular arc having its radius center in the center of terminal connection 7 on the emitter wiring pattern. In Fig.23, only a half portion on the right-hand side of insulation substrate 13 is shown since its semiconductor devices and wiring circuits are disposed symmetrically relative to a virtual center line 11 drawn vertically in the center of insulation substrate 13. A closest radius distance 23 from the center of terminal connection 7 on the emitter wiring pattern to the center of a closest semiconductor device, and a remotest radius distance 24 from the center of terminal connection 7 on the emitter wiring pattern to the center of a remotest semiconductor device are specified to be within ±20% of an average radius distance between the center of terminal connection 7 on the emitter wiring pattern and the centers of respective semiconductor devices. Thereby, each distance from the center of each IGBT semiconductor device and each diode semiconductor device to the terminal connection 7 on the emitter wiring pattern can be minimized equally, and also each length of wire-bonding between each electrode of each semiconductor device and its associated terminal connection can be substantially equalized.

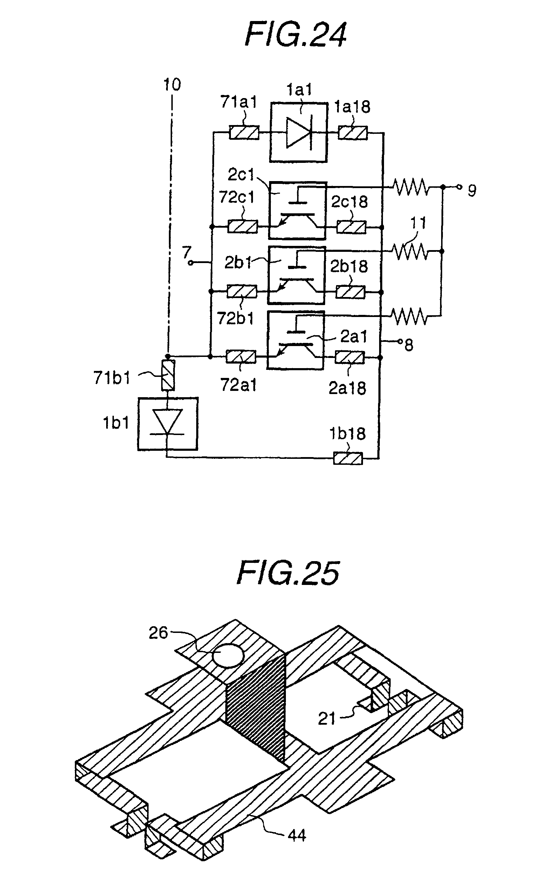

With reference to Fig.24, an equivalent circuit of Fig.23 is indicated. Inductance components due to wiring from terminal connection 8 on the collector wiring pattern to respective semiconductor devices are depicted by 1a18, 2c18, 2b18, 2a18 and lba8. Inductance components due to wiring from terminal connection 7 of emitter wiring pattern to respective semiconductor devices are depicted by 71a1, 72c1, 72b1, 72a1 and 71b1. These wiring is formed by the copper foils and bonding wire 6 on the surface of insulation substrate 13. In the case where there is a substantial difference among these inductance components, there occurs a difference in voltage fluctuations which are proportional to a rate of change of current, which causes malfunction of switching or even destruction of semiconductor devices. According to this embodiment of the invention, however, the above-mentioned inductance components 1a18, 2c18, 2b18, 2a18 and 1ba8 as well as 71a1, 72c1, 72b1, 72a1 and 71b1 which are proportional to their length of wiring can be suppressed to minimum and can be made substantially equal from each other by arranging the semiconductor devices on the circular arc as described above. Thereby, it becomes possible to minimize a voltage fluctuation which occurs in proportion to inductance components, thereby ensuring its semiconductor module to be operated electrically stably.

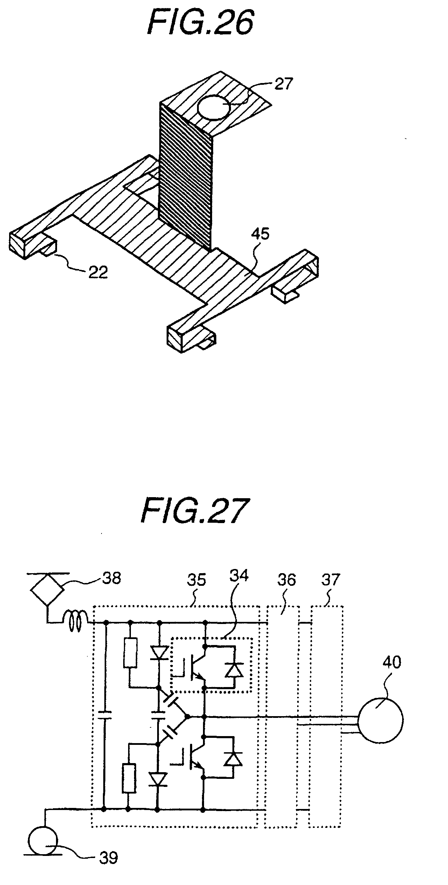

Fig.22(c) shows schematically respective interconnections of emitter terminal wiring connection 20, collector terminal wiring connection 21, gate terminal wiring connection 22 and auxiliary emitter terminal wiring connection 20 on the copper bonded insulation substrate, and also their terminal wirings to respective terminals' external connections on the semiconductor module of the invention as observed from the top side thereof. Fig.25 is a perspective view of emitter terminal wiring 26, and Fig.26 is a perspective view of collector terminal wiring 27 of the invention. Both emitter terminal wiring 26 and collector terminal wiring 27 have a symmetrical form with respect to a center line of the semiconductor module.

As a result of measurements of a current that flows through each semiconductor device, it is confirmed that a value of each current flowing through each semiconductor device falls within ±10% of its average value. Further, since the diode semiconductor devices can be placed adjacent both to emitter wiring pattern terminal connection 7 and auxiliary emitter wiring pattern terminal connection 10, interference to gate terminal wiring 18 caused by a recovery current that flows from the diode semiconductor devices can be minimized.

Still further, since respective semiconductor devices are arranged on a circular arc, a ratio of a major side LX of insulation substrate 13 to a minor side LY thereof can be set that LX/LY<1.5. Thereby, there occurs no significant difference in stress applied to the wiring patterns in the module between the major side and the minor side, hence no peel-off of any wiring pattern occurred as a result of heat cycle tests over 500 cycles. Further, no crack was observed after wire-bonding of respective semiconductor devices. Also, no crack was observed in insulation substrate 13 after having mounted the power module on a heat sink.

Still further, the arrangement of respective semiconductor devices on the circular arc according to the invention which is effective to distribute heat generation sources uniformly is advantageous over the conventional arrangement in which semiconductor devices were aligned in two rows in that heat dissipation is improved substantially and that thermal resistance is minimized.

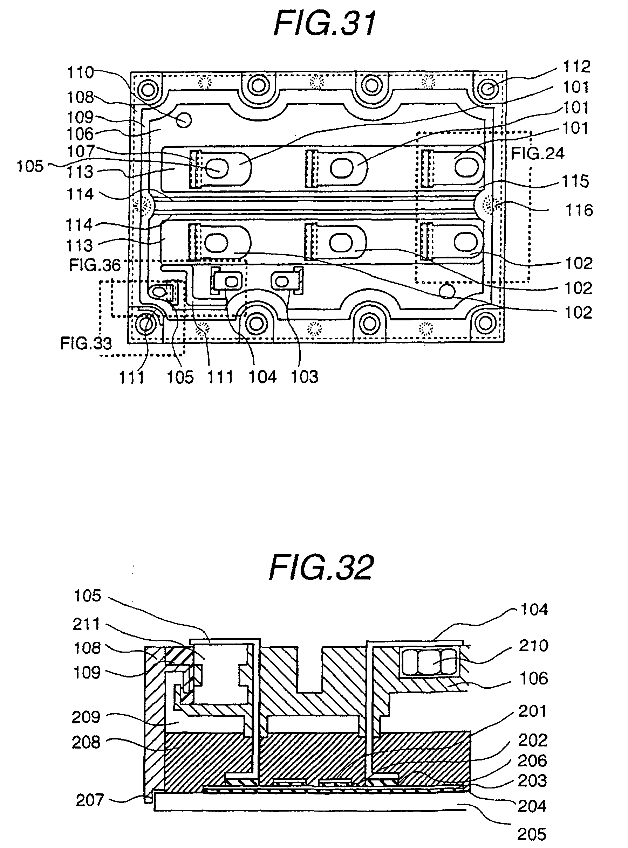

Furthermore, since respective semiconductor devices are not aligned in one direction as indicated in Fig.30(a), a gap LC between two adjacent semiconductor devices which is secured for positioning them on a jig when fabricating the semiconductor module can be reduced substantially. By way of example, Fig.30(a) is an example of the invention, whileas Fig.30(b) is a conventional one. Conventionally, a protrusion 49 is provided in part of a jig 48 as a guide to position each semiconductor device on a jig as indicated in Fig.30(b). According to the invention, since respective semiconductor devices are not aligned laterally in two parallel rows in one direction, they can be arranged using corners of the jig as a guide, thereby eliminating conventional protrusion 49, and substantially reducing the gap LC between adjacent semiconductor devices.

As to gel injection ports in reference to Fig.20, they are provided diagonally with respect to insulation fin 33 disposed in the center on semiconductor module 41. Gel injection port cap 32a is disposed to the collector side and gel injection port cap 32b is disposed to the emitter side on the module 41. By this arrangement of gel injection ports, even if semiconductor module 41 is tilted during gel injection, by measurement of a height between the gel injection port and a surface of gel, a tilt of semiconductor module 41 can be sensed, thereby capable of preventing exposure to atmosphere of any terminal wiring within the module, that is, including emitter terminal wiring 16, collector terminal wiring 17, gate terminal wiring 18 and auxiliary emitter terminal wiring 23. Further, with respect to internal structures under collector side gel injection port cap 32a and emitter side gel injection port cap 32b, it is arranged such that a planar portion 44 of emitter terminal wiring 16 which is parallel with the main surface of the base substrate is allowed to overlap less than 50% with a planar portion 45 of collector terminal wiring 17 which is parallel with the main surface of the base substrate. Thereby, gel is allowed easily to flow into the rear sides of planar portions 44 and 45, thereby preventing air void to be formed therein.

With reference to Fig.27, there is shown a circuitry diagram of an inverter apparatus using the semiconductor module of the invention. The inverter apparatus is comprised of inverter units U35, V36 and W37 for controlling operation of a three-phase motor 40. In each inverter unit described above, semiconductor module 41 of Fig.20 embodying the invention is applied to an inversion parallel circuit 34 having an IGBT and a diode. An upper arm inversion parallel circuit 34 on the side of a feeder line contact 38 is electrically coupled to wiring from the feeder line at its collector side of inversion parallel circuit 34 and a wiring from its emitter side thereof is electrically coupled to motor 40. On the other hand, a bottom arm inversion parallel circuit 34 on the side of ground connection 39 is electrically coupled to a wiring from ground connection 39 at its emitter side thereof, and a wiring from its collector side thereof is electrically coupled to the motor 40.

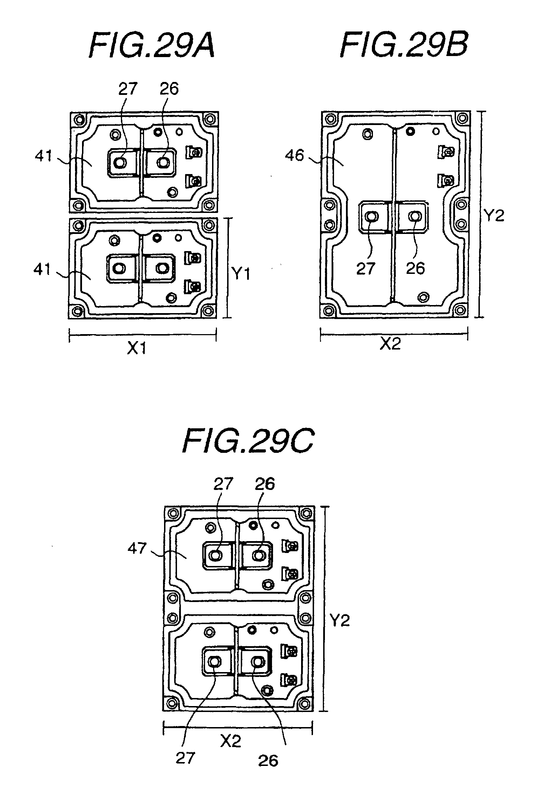

Since a semiconductor module embodying the invention is applied, a more compact sized inverter apparatus can be provided. Since semiconductor module 41 embodying the invention has its emitter terminal external connection 26 and its collector terminal external connection 27 being aligned parallel to the direction of the major side of the module, it is advantageous in assembling semiconductor modules 41 in parallel connections and electrically wiring therebetween using bus bars the layout of which is substantially simple, thereby contributing to provision of a more compact sized inverter apparatus. Further, insulation fin 33 is disposed at a position which is within 10% from the center of the semiconductor module 41, and both emitter terminal's external connection 26 and collector terminal's external connection 27 are disposed symmetrically with respect to the insulation fin at respective positions therefrom which are within 20% of a length of the major side of the module. Thereby, collector side bus bar wiring 42 and emitter side bus bar wiring 43 in the inverter apparatus can be provided substantially in the same shape and length. Hence, there occurs substantially no difference in wiring inductance therebetween, and voltage fluctuations due to switching can be suppressed within ±10% on both the emitter and the collector sides. Further, with reference to Fig.29, semiconductor module 41 of embodiment 1 of the invention has a dimension in which a length Y1 of its minor side is substantially proportional to a current capacity of the module, and a length X1 of its major side is substantially the same. Thereby, two semiconductor modules 41 in parallel connection can be replaced by one semiconductor module having a two-fold rating thereof. Both semiconductor module 46 in Fig.29(b) and semiconductor module 47 in Fig.29(c) depict a semiconductor module having a two-fold rating of that of Fig.29(a). Length X2 on a minor side of the two-fold rating semiconductor module is equal to length X1 on the major side of the semiconductor module of Fig.29(a), and length Y2 on a major side of the two-fold rating semiconductor module has a length which is substantially proportional to a current ratio relative to length Y1 on the minor side of the semiconductor module of Fig.29(a). Namely, in the case of Figs.29(b) and 29(c), the major side length Y2 is twice the minor side length Y1. Actually, when mounting two semiconductor modules 41 in parallel connection, a gap is secured between these two semiconductor modules, thereby the two-fold rating semiconductor module has a dimension taking into account this gap.

Two-fold rating semiconductor module 46 in Fig.29(b) is provided with one emitter terminal external connection 26 and one collector terminal external connection 27, respectively. Thereby, the number of connections with bus bar wiring is halved, thereby providing an inverter apparatus the maintenance and inspection of which becomes substantially easier. Still further, in the two-fold rating semiconductor module 47 having a two-fold capacity of semiconductor module 41 as indicated in Fig.29(c), two emitter terminal external connections 26 and two collector terminal external connections 27 are provided at substantially the same positions corresponding to their positions on two separate semiconductor modules 41 in Fig.29(a). Thereby, most of components of the semiconductor module can be shared therebetween as common components, and in addition, the semiconductor module 41 can readily be replaced by a two-fold rating semiconductor module 47 without changing their bus bar wiring. Thereby, without need of changes in mount positions of semiconductor modules and bus bar wiring, a large capacity semiconductor module can be assembled as an inverter apparatus.

As clearly understood from the above description, in the semiconductor module according to the invention having a plurality of semiconductor devices, more specifically having more than six semiconductor devices, each current that flows through each of the plurality of semiconductor devices can substantially be equalized, and thereby realizing an electrically stable semiconductor module having stable electrical properties suitable for the inverter apparatus.

Now, another power semiconductor module will be described in the following with reference to the accompanying drawings.

Fig. 31 is a plan view of a power semiconductor module, and Fig. 32 is a cross-sectional view in part of this module. A basic internal unit of the module is comprised of a plurality of semiconductor devices 201 and a copper clad substrate 203 having, for example, Cu/AlN/Cu structure, on the surface of the copper clad substrate 203 there are solder-bonded the plurality of semiconductor devices 201. This unit 203 is further bonded using insulation substrate connection solder 204 to a bottom metal substrate 205 made of, for example, a Cu or Cu alloy plate so as to compose one power semiconductor module. A collector terminal 101, emitter terminal 102, gate terminal 103, emitter sense terminal 104 and collector sense terminal 105 which are connected to each unit substrate using terminal connection solder 206 are led out therefrom outside the module. These terminals are provided having been molded using terminal fixing thermosetting epoxy resin 107 integrated in a terminal block 106 made of resin. Further, a nut 210 for fastening each terminal and an insert nut 211 formed integral with the terminal block are set in the terminal block 106. After bonding the bottom metal substrate 205 having mounted semiconductor devices 201 with the terminal block 106, a resin case 108 is bonded thereto using silicone adhesive 207. Resin case 108 and terminal block 106 are bonded integral with each other to seal inside the module using thermosetting epoxy resin 109 via a crank structure therebetween which is formed in the whole periphery of the module. Then, silicone gel 208 is poured through resin inlet 110 provided in terminal block 106. After hardening of the gel, a cap made of silicone rubber is set on the resin inlet to seal inside the module. A sufficient amount of silicone gel 208 is poured into the module to ensure that any part of any terminals are not exposed to ensure intra-module electrical insulation. A space 209 is, however, secured inside the module to absorb thermal deformation of silicone gel 208.

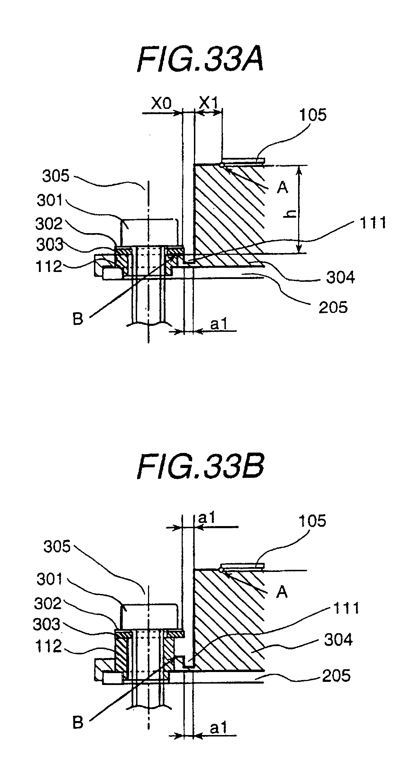

In order to secure electrical insulation in the module having a terminal layout of Fig.31, there are required respective insulation between collector terminal 101 and emitter terminal 102, between emitter terminal 102 and collector sense terminal 105, between emitter sense terminal 104 and collector sense terminal 105, and between each terminal and bottom metal substrate 205, respectively. A method for securing such electrical insulation by means of providing a creep distance between respective terminals and between these terminals and the bottom metal substrate will be described in the following with reference to Figs. 33 to 37.

Fig. 33(a) shows a cross-section of a structure of a power semiconductor module and a creep distance A-B between collector sense terminal 105 and bottom metal substrate 205. A feature of this structure resides in that its actual creep distance of A-B between collector sense terminal 105 and a component which is closest thereto and at the same potential as that of the bottom metal substrate 205 is longer than a total distance obtained by adding a shortest distance X0 between the case wall and a closest component thereto which is at the same potential as module bottom metal substrate 205, a height distance h between a lower module surface with which a bottom surface of a module fastening bolt 301 contacts and the height of the terminal 105, and a minimum distance X1 between the case wall and the terminal 105. Normally, when a module is assembled, its bottom metal substrate 205, module fastening bolt 301, spring washer 302, and plate washer 303 are at the same potential. In this embodiment of a power semiconductor module, a creep distance between A and B is secured by providing an insulation groove 111 in the lower surface of the module with which the bottom side of module fastening bolt 301 is in contact via spring washer 302 and plate washer 303. A dimension of this insulation groove 111 is determined by a module environment and a module rating. In this embodiment of a power semiconductor module, since its environment is normal, and its insulation rating is 126 V or more, a minimum gap a1 is secured, wherein a1≥1mm. Further, in order to ensure insulation groove 111 provided in the lower surface of the module in contact with the bottom side of module fastening bolt 301 to be maintained effective, positioning of a case ring centre 305 is determined such that a minimum distance of a1 or more is secured between spring washer 302 or plate washer 303 having the same potential as that of module fastening bolt 301 and case wall 304. Provided that a minimum distance of a1 is secured therebetween, a height of case ring 112 can be raised from the lower surface of the module as depicted in Fig. 33(b). By raising the height of case ring 112, stress to be exerted on module fastening bolt 301 as a result of thermal deformation of the module during operation can be reduced. According to these advantages and effects described above, collector sense terminal 105 can be placed as near as possible toward the case wall at a reduced distance X1. In the structure of this embodiment of a power semiconductor module, insert nut 211 is used as a nut for use in fastening collector sense terminal 105, and this insert nut 211 can be disposed toward resin case 108 as near as to contact with a crank member of resin case 108. At this time, a part of metal surface of insert nut 211 to the side of the crank member of terminal block 106 is exposed. However, since this exposed surface is then embedded in thermosetting epoxy resin 109 which is used for bonding resin case 108 and terminal block 106, there will be no problem.

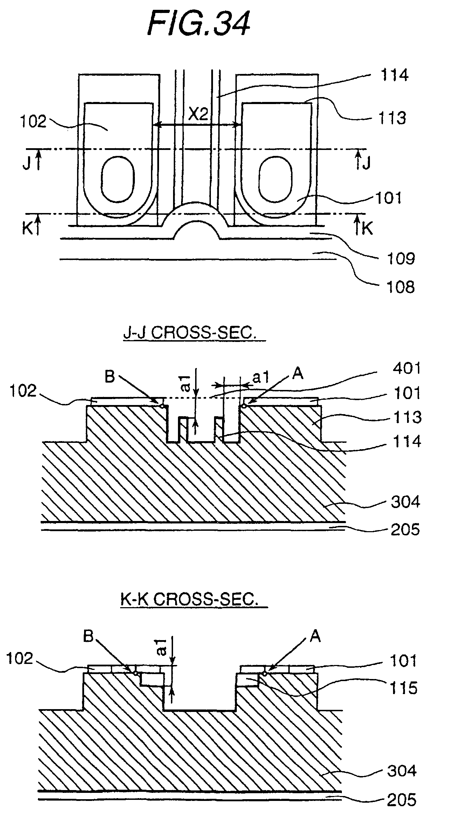

Fig. 34 is a cross-section of a gap provided between collector terminal 101 and emitter terminal 102. Features of this structure of a power semiconductor module reside in that its actual creep distance between these terminals is longer than a shortest distance X2 therebetween, and that a height of insulation wall 114 is lower than a virtual plane 401 drawn between upper surfaces of terminals 101 and 102 by a height of a1 required for securing electrical insulation. In this example, this height of a1 is ensured to be a1=1mm or more in consideration of the above-mentioned conditions. In J-J cross section, a creep distance A-B is secured by a combination of a groove and insulation wall 114. In K-K cross section, end portions of terminals 101 and 102 are rounded, and for securing a creep distance, insulation step 115 having a vertical gap of a1 is provided in a main terminal's bottom side contact surface 113 of terminal block 106.

On the other hand, provision of main terminal's bottom side contact surface 113 is limited to a region where wire connection nuts for fastening terminals 101 and 102 are used, and is not provided extending to the outer periphery of the module. Thereby, a part of wiring for interconnection between main terminals is allowed to float thereby improving cooling efficiency therefor. Further, a space is secured for installing signal lines when assembling modules. Still further, freedom of directions for leading out signal lines increases.

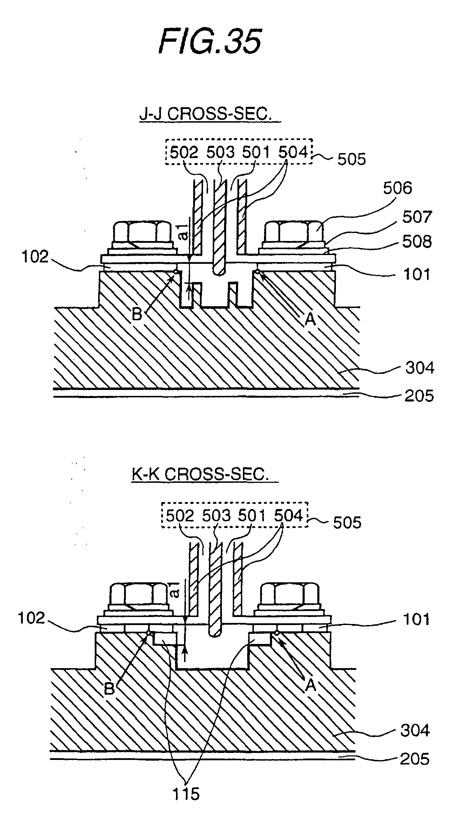

Fig. 35 shows J-J and K-K cross-sections of examples where collector terminal 101 and emitter terminal 102 are wired using a laminate bus bar 505. Laminate bus bar 505 connects in the same manner its collector wiring 501 and its emitter wiring 502 to collector terminal 101 and emitter terminal 102 respectively using bolt 506 via spring washer 507 and plate washer 508. Respective wiring 501 and 502 having been insulated from each other by interwiring insulation plate 503 interposed therebetween and integrated by being covered entirely by wiring coat insulation material 504 therearound are raised upward vertically from the centre of the module. By provision of this integrated wiring, mutual inductance due to external wiring outside the module is almost completely cancelled. This effect is particularly substantial for a module which wires its IGBT units outside the module. By way of example, laminate bus bar 505 does not have wiring coat insulation material 504 on its bottom surface in contact with terminals 101 and 102 in order to avoid any imperfect contact therewith. In the J-J cross section of the power semiconductor module, since a minimum insulation distance a1 is secured from the upper surface of terminals 101, 102, that is, from laminate bus bar 505 to insulation walls, its creep distance A-B via the insulation walls does not change. On the other hand, in the K-K cross section having no insulation walls, since insulation steps 115 having insulation distance a1 are provided under terminals 101 and 102, its creep distance A-B does not change. It should be noted, however, that in a power semiconductor module, if it uses any type of parallel plate wirings leading upward from terminals 101 and 102 other than the laminate bus bar 505, its creep distance will not be reduced.

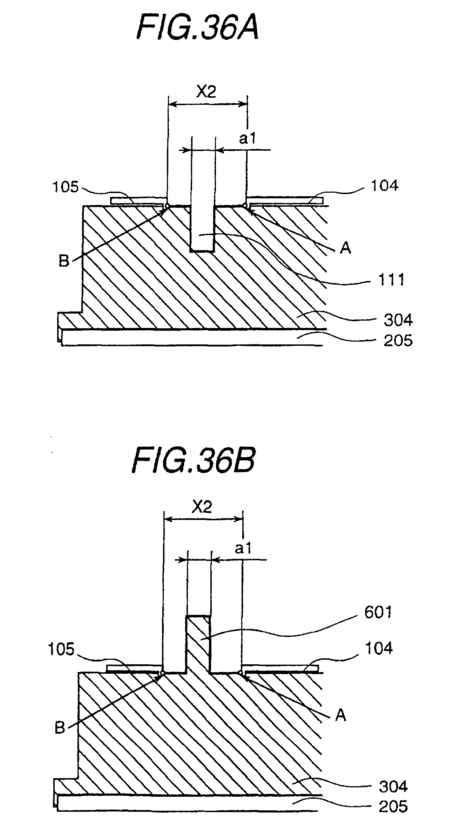

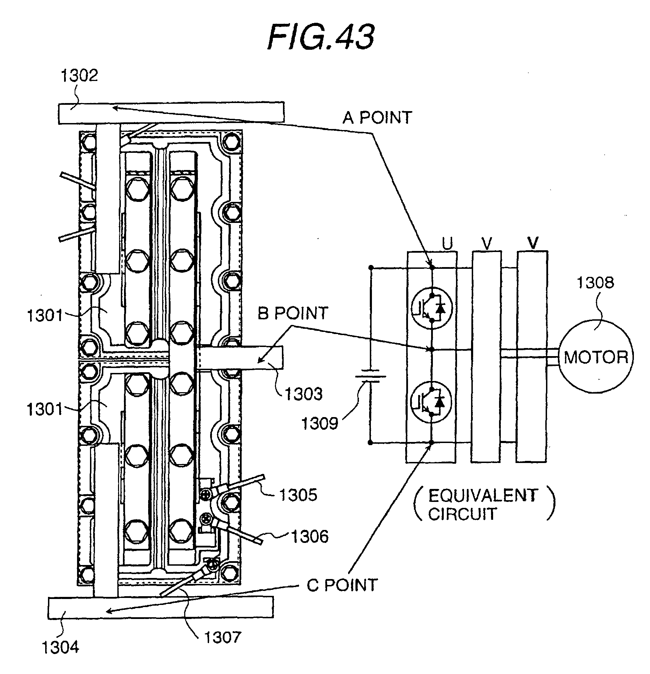

Figs. 36 (a) and (b) show a cross-section of a gap structure formed between collector sense terminal 105 and emitter sense terminal 104 in a power semiconductor module. A feature of this gap structure is that its creep distance is longer than a minimum horizontal distance X2 between these terminals, and that its insulation groove or insulation wall is provided only in two directions around each terminal. First of all, a minimum width a1 of its groove or insulation wall is secured to be a1 ≥ 1mm from the aforementioned condition. Its plan view is indicated in the left-bottom portion in Fig. 31. Groove 111 is formed to have a crank shape which faces two sides of collector sense terminal 105 and also two sides of emitter sense terminal 104. By provision of this groove 111, collector sense terminal 105 ensures respective creep distances from emitter terminal 102 and emitter sense terminal 104. In the case of provision of groove 111, as will be described with reference to Fig. 43, freedom of terminal wiring improves substantially. Further, thickness of the resin member of terminal block 106 in the periphery of nuts 210, 211 for fastening terminal wiring (in reference to Fig. 32) can be increased thereby preventing occurrence of crack in the resin member when fastening of the bolt. Fig. 36(b) shows a cross-section of another gap structure having insulation wall 601 instead of the groove to the same effect. Although it depends on a particular environment of the module, for example, where cooling air is supplied from one direction for cooling the module externally, provision of such insulation wall in the crank shape will help to protect the module from dust which may deteriorate electrical insulation. Directions of bend of emitter sense terminal 104 and collector sense terminal 105 are folded backward from each other in opposite directions relative to the groove as indicated in Fig. 32. By such arrangement, variance of creep distance between terminals due to a tilt of terminal bend can be reduced. Still further, since parallel planes rising vertically in the module can be placed in close proximity from each other, noise interference can be minimized.

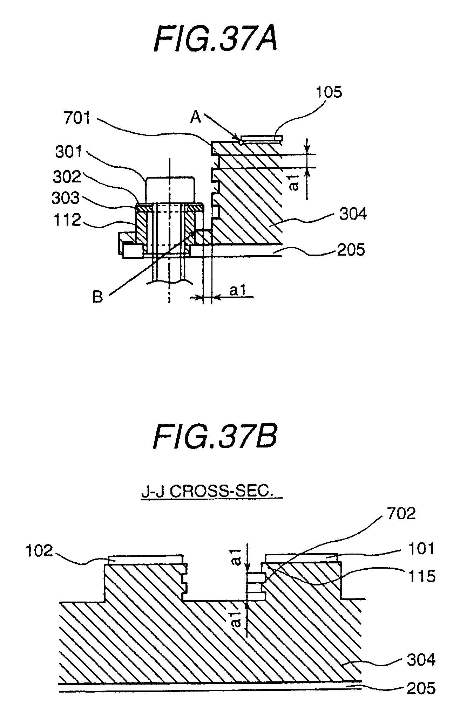

Fig. 37 shows an example which secures its creep distance along the side wall of its case. Fig. 37(a) is a cross-section of a gap structure provided between collector terminal 105 and bottom metal substrate 205. According to this method in the same manner as in Fig. 33, a creep distance which is longer than a sum of distances X0+h+X1 can be realized, wherein X0 is a shortest distance between the side wall of the case and a component which is at the same potential as that of bottom metal substrate 205 of the module; h is a height between a lower surface of the module which is in contact with the bottom surface of fastening bolt 301 for mounting the module and the upper surface of the module on which the terminal is placed; and X1 is a shortest distance between the side wall of the case and the terminal. In order to realize this effect, it is necessary to secure a gap a1 which is equal to 1mm or more as described above between respective insulation walls provided in the side wall of the case. Further, a lateral distance at least of a1 is secured between the side of plate washer 303 for use in fastening the module and insulation wall 701 provided in the side wall of resin case 304. Fig.37(b) is an example having insulation walls 702 provided in the side wall of the case between collector terminal 101 and emitter terminal 102. In this example, also, a gap a1 which is 1mm or more is secured between respective insulation walls 702 provided in the side wall between main terminals, likewise in Fig.37(a). This method has such advantage that even if a deep groove or insulation wall cannot be formed in the surface of the module due to limitation of other surface arrangement thereof, an adequate creep distance can be secured in the side wall. Still further, there is another advantage that since its surface area in the periphery of the module increases, its cooling efficiency improves substantially. A protrusion instead of the groove or any type of irregular surfaces available for securing a creep distance can be utilized where it is needed to the same effect, for example, even by a company logo having irregular surfaces attached externally.

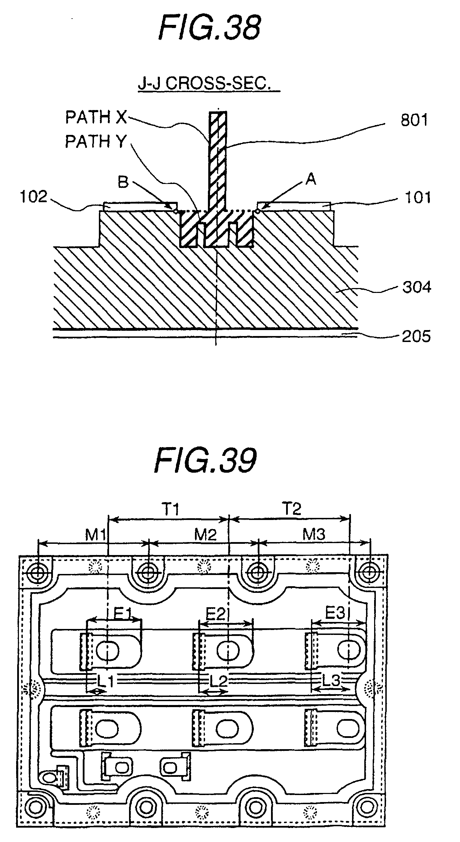

Fig.38 is an example where a post-insert insulation wall 801 is inserted between collector terminal 101 and emitter terminal 102. A separate post-insert insulation wall 801 made of resin is fixed using for example silicone adhesive between terminals 101 and 102 in the module having been explained with reference to Fig.31. In this case, there will be no problem provided that a creep distance Y secured by the preceding method and a creep distance X secured by the post-insert insulation wall 801 are substantially the same. Further, although it is not shown in the drawing, a post-insert insulation wall can be inserted into the groove 111 provided between emitter sense terminal 104 and collector sense terminal 105 in order to eliminate the groove from the entire surface of the module. Thereby, when the module is used in an environment where air dust is not controlled, by provision of this post-insert insulation wall, a problem of insulation deterioration by dust accumulation will be prevented. Still further, when wiring material without insulation coating is used for inter-module wiring, this post-insert insulation wall 801 will provide for a spatial distance needed between any two adjoining wirings.

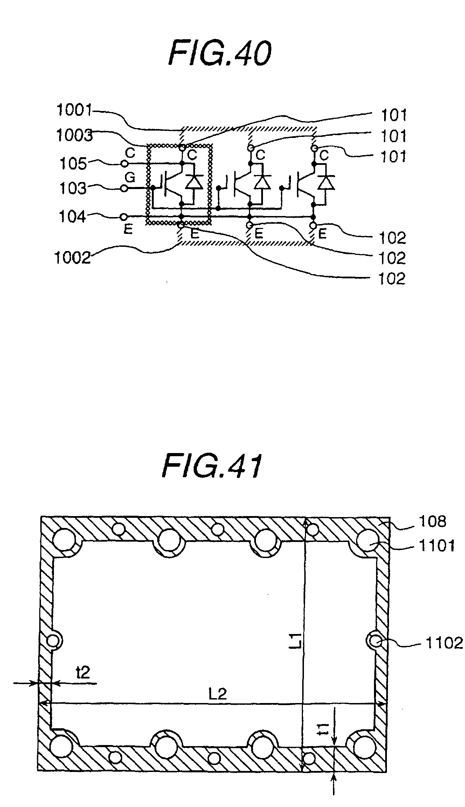

Fig.39 shows terminal arrangement of this power semiconductor module. Fig. 40 shows a circuit diagram of this power semiconductor module. As to terminal arrangement of the module, collector terminal 101 and emitter terminal 102 are provided in three positions, respectively. This circuit of the module is comprised of each unit 1003 having integrated IGBT and a free-wheeling diode provided separately in the module. Gate terminal 103 and emitter sense terminal 104 are interconnected between respective units within the module, and each of these terminals 103 and 104 is led out of the module using a single line as its external terminal. A single external terminal line as collector sense terminal 105 is wired from one of these separate IGBT units 1003. In operation of a module assembled, each collector terminal 101 and emitter terminal 102 corresponding to each unit are short-circuited outside the module via each wiring 1001 and 1002. As to positioning of external terminals outside the module, in order to be able to share as many common components of the same shape for constituting internal construction of the module, each wiring connection positioning gap T1 between respective main terminals, and each module fixing hole pitch M1 are set such that T1=T2 and M1=M2=M3, respectively. However, as indicated in this power semiconductor module, depending on respective circumstances of module assembly, respective wiring connection positioning gap T1 and T2 may be varied, and respective module mount hole pitches M1, M2 and M3 can be varied as well. At this time, wiring connection positions L1, L2 and L3 with respect to external appearance of respective main terminals E (where E1=E2=E3) can be varied for each main terminal, thereby allowing respective main terminals to be provided in the same outer dimensions even if module mount hole positioning pitches M1, M2 and M3 are varied and main terminal wiring connection positioning pitch T1 and T2 are different. Thereby, their terminals can be manufactured using a same die machine, and which are then punched according to their respective wiring connection positions. Thereby, internal layout within the module can be specified independent of the wiring connection positioning.

Fig. 41 shows a bottom surface of resin case component 108 of the power semiconductor module. In the bottom surface of the resin case 108, there are provided module mount hole 1101 disposed in the periphery thereof, and insert nut 1102 integrated therein for receiving a bolt which fastens resin case 108 with module bottom metal substrate 205. A shaded area depicts a region which is bonded with the bottom metal substrate using silicone adhesive. In this power semiconductor module, resin thickness t1 on a major side L2 is provided thicker than resin thickness t2 on a minor side L1, where L1<L2 and t1>t2. Direction of warp or deflection after assembly of the module is greatest in vertical directions of the module. In particular, in the module structure having space 209 inside the module, since deformation in the side wall of the module is extremely small, it is required to consider only to suppress deformation in the bottom surface of module's bottom metal substrate 205. With respect to deformation in the vertical directions of the module, a direction of height of the case serves as a beam. By increasing the thickness of this beam, deformation of the module is suppressed. Further, when considering precision of manufacture of the case as a component, it was difficult to align dimensions of L1 both in the periphery and in the centre in a resin case having a large-sized frame, hence, spacers were inserted afterward and heated for their correction. However, by increasing the thickness of t1 to be greater than t2, precision of components improved substantially. Further, since an increased thickness of t1 has been secured, an increased area of bonding between resin case 108 and bottom metal substrate 205 is secured, thereby eliminating defects of peel-off of resin case 108 from bottom metal substrate 205 due to heat cycles or the like.

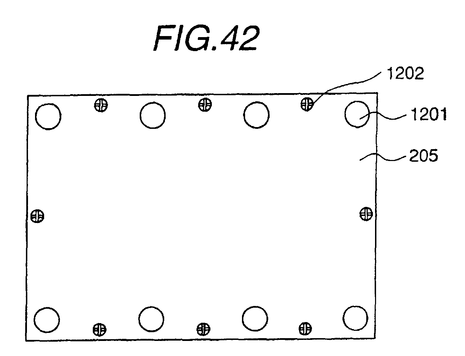

Fig. 42 shows a bottom surface of the power semiconductor module. Module mount hole 1201 is provided in bottom metal plate 205, and fastening screw 1202 for mechanically fastening resin case 108 of Fig. 38 with bottom metal plate 205 is also provided as disposed in the periphery of the metal plate. Bolts 116 for mechanically fastening resin case 108 are disposed in both directions of the major side and the minor side of the module. According to the conventional method whereby bolts are disposed only in the direction of the major side of the module, restraint only in one direction is secured. Thereby, after completion of the module, when the bottom surface of the module is warped, for example, in convex along the major side thereof, the minor side thereof is caused to deform in concave, thereby causing the directions of respective warp to be in the opposite directions. According to this embodiment of a power semiconductor module, however, the directions of respective warp along both the major side and the minor side in the bottom surface of the module can be coordinated in the same direction, for example, in convex. Thereby, reliability of adhesive bonding improves substantially, and occurrence of crack in the insulation substrates inside the module can be prevented.

Fig. 43 is a plan view of an IGBT module which is mounted in an inverter for use for driving a motor, and its equivalent circuit. Normally, IGBT modules 1301 are disposed in inverted arrangement such that their intermediate points B can be wired using a single intermediate point wiring 1303. Collector side wiring 1302 and emitter side wiring 1304 are wired respectively with U, V and W phases to supply from power source 1309. Signal lines from each IGBT module 1301 include gate wiring 1305, emitter sense wiring 1306 and collector wiring 1307. Since the insulation groove or insulation wall is provided only in two directions in the periphery of each signal line as described above, freedom in the directions of lead-out wiring increases. On the other hand, provision of plane 113 which is in contact with the bottom surface of the main terminals is limited only to an area where the connection fastening nuts for fastening main terminals 101, 102 are fixed, and does not extend to the periphery of the module. Thereby, since a part of intermediate point wiring 1303 can be disposed apart from the module, its heat dissipation effect can be improved. Further, since a distance in height at least a1 is secured for all insulation wall from the upper surface of a main terminal, freedom of layout of wiring is not limited.

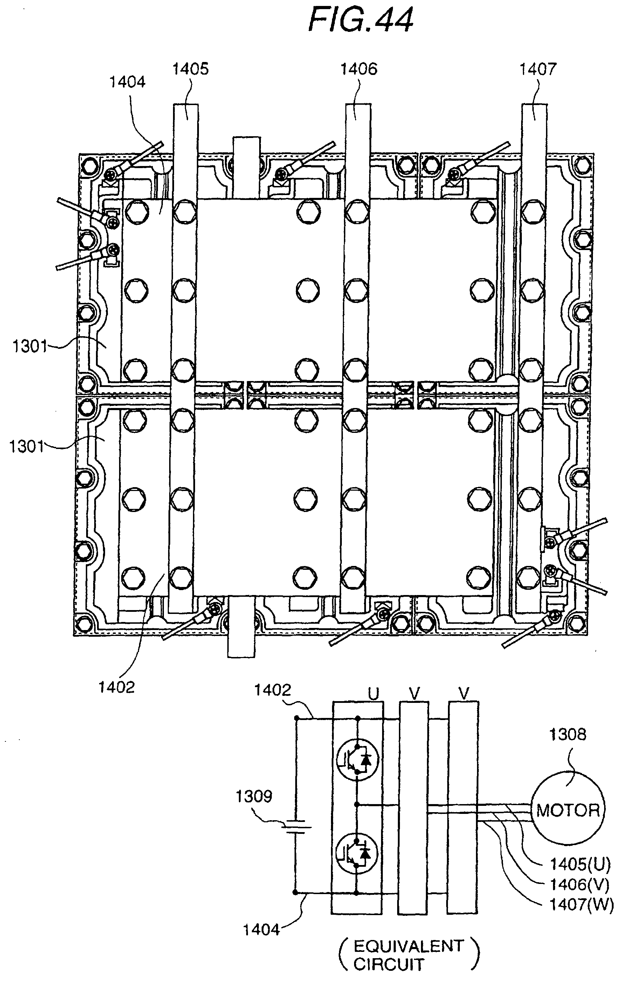

Fig. 44 shows an example of packaging IGBT module 1301 using parallel plate wiring. For this module, even if an electrode plate is disposed all over the upper surface of the module, electrical insulation is not impaired. Thereby, after packaging the module most densely, collector side wiring 1402 and emitter side wiring 1404 can be provided in plate form which covers between the modules. Further, by interposing a single electrical insulation layer on collector side wiring 1402 and emitter side wiring 1404, respective wirings U 1405, V 1406 and W 1407 to the load are disposed on the upper surface of the module. Thereby, since wiring areas are reduced, the size of the inverter can be reduced. Use of parallel plate wirings can reduce inductance due to wiring.

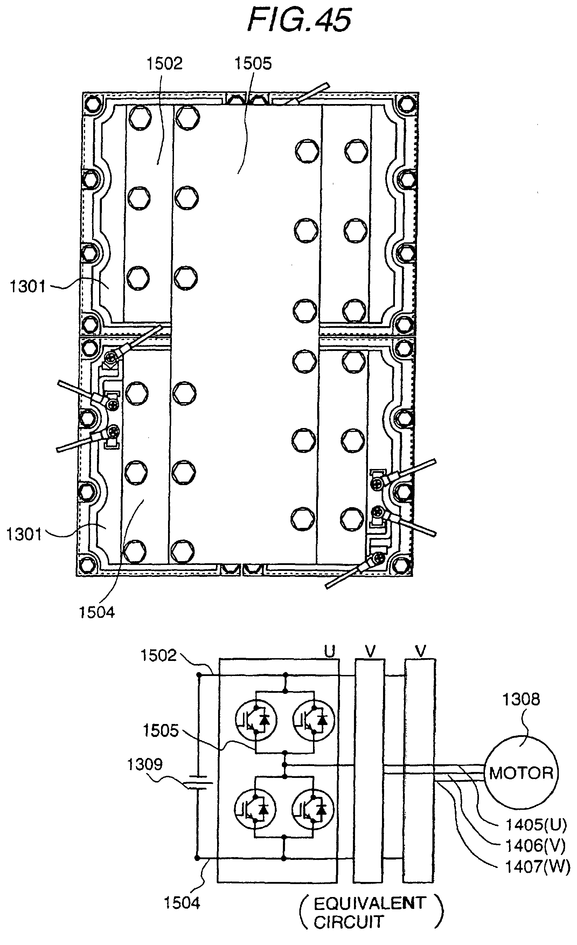

Fig. 45 shows an example of arrangement of modules in which power semiconductor modules are connected in parallel, and its equivalent circuit. When a current capacity to control is increased, a control capacity of an inverter can be increased by connecting modules in parallel. Inter-module wiring is provided in the same way as in Fig. 44 by wiring collector side wiring 1502 and emitter side wiring 1504 such as to cover the upper surface of the module. Load wiring 1503 to the load is disposed on the upper surface of the module via a single insulation layer interposed on collector side wiring 1502 and emitter side wiring 1504. Thereby, a compact-sized and low-impedance inverter can be provided which is capable of controlling a current capacity twice the rating of the module.

## Claims

1. A power semiconductor module comprising:
- a substrate (109) having a major surface lying in a first plane, first and second insulation substrates (103) provided on the major surface of the substrate (109), the first and second substrates (103) being provided symmetrically on either side of a first axis (x) arranged centrally along the module;
- a plurality of power semiconductor devices (101, 102) mounted on each of said insulating substrates (103) and electrically connected together to form a circuit unit, whereby corresponding power semiconductor devices (101, 102) on each of the first and second substrates (103) are arranged symmetrically on either side of the first axis (x);
- first and second external power terminals (301, 401) for providing current to the power semiconductors, each of said first and second power terminals (301, 401) comprising first and second connecting portions connecting the terminals to first and second connecting points (302-305, 402-405) on the first and second insulating substrates respectively, whereby for each of the first and second terminals (301, 401), the first and second connecting points (302-305, 402-405) thereof are positioned symmetrically on either side of the first axis (x);
- whereby the power semiconductor devices of said first and second substrates (103) are electrically connected in parallel;
**characterized in that**
- each of the first and second connecting portions of the first and second power terminals (301, 401) has an S-shaped bend in a portion proximate the first or second connecting point (302-305, 402-405), the S-shaped bend lying in a second plane perpendicular to the first plane, whereby the direction normal to the surface of the second plane is orthogonal to the direction of the first axis (x); and
- the first connecting points (302, 303, 402, 403) on the first substrate are aligned along a second axis parallel to the first axis (x), and the second connecting points (304, 305, 404, 405) on the second substrate are aligned along a third axis parallel to the first axis (x).

2. A power semiconductor module according to claim 1, wherein control wiring is provided on the substrate (109) for controlling the power semiconductor devices, whereby portions (1302) of the control wiring that lie parallel to the first axis (x) are arranged in the periphery of the module to be remote from the power terminals, and portions (1304, 1305) of the control wiring that are in proximity to the power terminals are disposed to be perpendicular to the first axis (x), and the control wiring forms a loop circuit within the module.

3. A power semiconductor module according to claim 1, wherein the vertical height of each of the S-shaped bends above the substrate is the same; the first and second terminals respectively comprise a first and second plane portion with each of the first and second plane portions connecting the first and second terminal connecting portions; and the first and second plane portions are overlaid in a direction vertical to the first plane.

4. A power semiconductor module according to claim 2, **characterized in that** electrical insulation between respective terminals (301, 401) is secured by a spacer of insulating material.

5. A power semiconductor module according to claim 4, **characterized in that** said spacer of insulating material includes a first spacer (1501) which is formed integral with a terminal block (205) and which fixes the respective terminals (401, 301) in position through respective holes formed therethrough, and a second spacer (1502, 1601) which is disposed near the first spacer (1501) and between respective terminals (401, 403) so as to keep a predetermined gap (T) therebetween while permitting silicon gel filling into the gap around the first spacer (1501).

## Patentansprüche

1. Leistungshalbleitermodul
- mit einem Substrat (109), das eine in einer ersten Ebene liegende Hauptfläche und auf der Hauptfläche des Substrats (109) vorgesehene erste und zweite Isoliersubstrate (103) aufweist, wobei die ersten und zweiten Substrate (103) symmetrisch auf jeder Seite einer ersten Achse (x) vorgesehen sind, die zentral längs des Moduls angeordnet ist,
- mit einer Vielzahl von Leistungshalbleitervorrichtungen (101, 102), die auf jedem der Isoliersubstrate (103) angeordnet und elektrisch miteinander zur Bildung einer Schaltungseinheit verbunden sind, wodurch entsprechende Leistungshalbleitervorrichtungen (101, 102) auf jedem der ersten und zweiten Substrate (103) symmetrisch auf jeder Seite der ersten Achse (x) angeordnet sind, und
- mit ersten und zweiten externen Leistungsklemmen (301, 401) zum Bereitstellen von Strom für die Leistungshalbleiter, wobei jede der ersten und zweiten Leistungsklemmen (301, 401) erste und zweite Verbindungsabschnitte aufweist, die die Klemmen mit ersten und zweiten Verbindungspunkten (302 bis 305, 402 bis 405) an den ersten beziehungsweise zweiten Isoliersubstraten verbinden, wodurch für jede der ersten und zweiten Klemmen (301, 401) ihre ersten und zweiten Verbindungspunkte (302 bis 305, 402 bis 405) symmetrisch auf jeder Seite der ersten Achse (x) positioniert sind,
- wodurch die Leistungshalbleitervonichtungen der ersten und zweiten Substrate (103) elektrisch parallel geschaltet sind,
**dadurch gekennzeichnet,**
- **dass** jeder der ersten und zweiten Verbindungsabschnitte der ersten und zweiten Leistungsklemmen (301, 401) eine S-förmige Biegung in einem Teil in der Nähe des ersten oder zweiten Verbindungspunkts (302 bis 305, 402 bis 405) hat, wobei die S-förmige Biegung in einer zur ersten Ebene senkrechten zweiten Ebene liegt, wodurch die Richtung senkrecht zur Oberfläche der zweiten Ebene senkrecht zur Richtung der ersten Achse (x) ist, und
- **dass** die ersten Verbindungspunkte (302, 303, 402, 403) an dem ersten Substrat längs einer zweiten, zur ersten Achse (x) parallelen Achse ausgerichtet sind und die zweiten Verbindungspunkte (304, 305, 404, 405) an dem zweiten Substrat längs einer dritten zur ersten Achse (x) parallelen Achse ausgerichtet sind.

2. Leistungshalbleitermodul nach Anspruch 1, bei welchem eine Steuerverdrahtung an dem Substrat (109) zum Steuern der Leistungshalbleitervorrichtungen vorgesehen ist, wodurch Abschnitte (1302) der Steuerverdrahtung, die parallel zur ersten Achse (x) liegen, in der Peripherie des Moduls angeordnet sind, so dass sie von den Leistungsklemmen entfernt sind, und Abschnitte (1304,1305) der Steuerverdrahtung, die sich in der Nähe der Leistungsklemmen befinden, so angeordnet sind, dass sie zur ersten Achse (x) senkrecht sind, und bei welchem die Steuerverdrahtung in dem Modul eine Schleifenschaltung bildet.

3. Leistungshalbleitermodul nach Anspruch 1, bei welchem die vertikale Höhe jeder der S-förmigen Biegungen über dem Substrat die gleiche ist, die ersten und zweiten Klemmen jeweils einen ersten und zweiten ebenen Abschnitt bilden, wobei jeder der ersten und zweiten ebenen Abschnitte die ersten und zweiten Klemmenverbindungsabschnitte verbindet und die ersten und zweiten ebenen Abschnitte in einer Richtung senkrecht zur ersten Ebene übereinandergelegt sind.

4. Leistungshalbleitermodul nach Anspruch 2, **dadurch gekennzeichnet, dass** eine elektrische Isolierung zwischen entsprechenden Klemmen (301, 401) durch ein Distanzstück aus Isoliermaterial gesichert ist.

5. Leistungshalbleitermodul nach Anspruch 4, **dadurch gekennzeichnet, dass** das Distanzstück aus Isoliermaterial ein erstes Distanzstück (1501), das in einem Stück mit einem Klemmenblock (205) ausgebildet ist und die jeweiligen Klemmen (401, 301) durch entsprechende durch sie hindurchgehend ausgebildete Löcher in ihrer Position festlegt, und ein zweites Distanzstück (1502, 1601) aufweist, das nahe an dem ersten Distanzstück (1501) und zwischen entsprechenden Klemmen (401, 403) so angeordnet ist, dass ein vorgegebener Spalt (T) dazwischen aufrechterhalten wird, während das Einfüllen von Silikongel in den Spalt um das erste Distanzstück (1501) herum ermöglicht wird.

## Revendications

1. Module semi-conducteur de puissance comprenant :
un substrat (109) ayant une surface principale reposant dans un premier plan, un premier et un deuxième substrats d'isolation (103) fournis sur la surface principale du substrat (109), le premier et le deuxième substrats (103) étant disposés symétriquement sur chaque côté d'un premier axe central (x) le long du module ;
une pluralité de dispositifs semi-conducteurs de puissance (101, 102) montés sur chacun desdits substrats d'isolation (103) et connectés électriquement ensembles pour former un circuit unitaire, grâce à quoi les dispositifs semi-conducteurs de puissance (101, 102) sur chacun du premier et du deuxième substrats (103) sont disposés symétriquement sur chaque côté de l'axe (x) ;
une première et une deuxième bornes de puissance externes (301, 401) pour délivrer du courant aux semi-conducteurs de puissance, chacune desdites premières et deuxièmes bornes de puissance (301, 401) comprenant une première et une deuxième parties de connexion pour connecter les bornes à des premiers et deuxièmes points de connexion (302 à 305, 402 à 405) sur les premier et deuxième substrats d'isolation, respectivement, grâce à quoi pour chacune des première et deuxième bornes (301, 401), les premiers et deuxièmes points de connexion (302 à 305, 402 à 405) de celles-ci sont placés symétriquement sur chaque côté du premier axe (x) ;
grâce à quoi les dispositifs semi-conducteurs de puissance desdits premier et deuxième substrats (103) sont connectés électriquement en parallèle;
**caractérisé en ce que**
chacune des première et deuxième parties de connexion des première et deuxième bornes de puissance (301, 401 ) présentent un coude en forme de « S » dans une partie située à proximité des premiers ou deuxièmes points de connexion (302 à 305, 402 à 405), le coude en forme de « S » reposant dans un deuxième plan perpendiculaire au premier plan, grâce à quoi la direction normale à la surface du deuxième plan est orthogonale à la direction du premier axe (x) ; et
les premiers points de connexion (302, 303, 402, 403) sur le premier substrat sont alignés le long d'un deuxième axe parallèle au premier axe (x), et les deuxièmes points de connexion (304, 305, 404, 405) sur le deuxième substrat sont alignés le long d'un troisième axe parallèle au premier axe (x).

2. Module semi-conducteur de puissance selon la revendication 1, dans lequel un câblage de commande est prévu sur le substrat (109) pour commander les dispositifs semi-conducteurs de puissance, grâce à quoi des parties (1302) du câblage de commande placées parallèlement au premier axe (x) sont disposées à la périphérie du module pour être éloignées des bornes de puissance et des parties (1304, 1305) du câblage de commande situées à proximité des bornes de puissance sont disposées pour être perpendiculaires au premier axe (x), et le câblage de commande forme un circuit bouclé à l'intérieur du module.

3. Module semi-conducteur de puissance selon la revendication 1, dans lequel la hauteur verticale de chacun des coudes en forme de « S » au-dessus du substrat est la même ; les première et deuxième bornes comprennent respectivement une première et une deuxième parties plates, chacune des première et deuxième parties plates étant connectées aux première et deuxième parties connectant les bornes ; et la première et deuxième parties plates sont superposées dans une direction verticale par rapport au premier plan.

4. Module semi-conducteur de puissance selon la revendication 2, **caractérisé en ce que** l'isolation électrique entre les bornes respectives (301, 401) sont fixées par une entretoise constituée d'un matériau isolant.

5. Module semi-conducteur de puissance selon la revendication 4, **caractérisé en ce que** la dite entretoise en matériau isolant inclut une première entretoise (1501) faisant partie intégrante d'une plaque à bornes (205) et maintenant les bornes respectives (401, 301) en position grâce à des trous respectifs formés à travers celle-ci et une deuxième entretoise (1502, 1601) qui est déposée à proximité de la première entretoise (1501) et entre les bornes respectives (401, 403) afin de maintenir un espacement prédéterminé (T) entre celles-ci tout en permettant de remplir l'espacement situé autour de la première entretoise (1501) par du gel de silicone.
